(19) Europäisches Patentamt
European Patent Office
Office européen des brevets

(11) **EP 4 783 464 A1**

(12) **EUROPEAN PATENT APPLICATION**
published in accordance with Art. 153(4) EPC

(43) Date of publication:
**29.07.2026 Bulletin 2026/31**

(21) Application number: **23956529.4**

(22) Date of filing: **27.10.2023**

(51) International Patent Classification (IPC):
**H03M 7/30** (2006.01)

(52) Cooperative Patent Classification (CPC):
**H03M 7/30**

(86) International application number:
**PCT/CN2023/127332**

(87) International publication number:
**WO 2025/086289 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **HUAWEI TECHNOLOGIES CO., LTD.
Shenzhen 518129 (CN)**

(72) Inventors:
• XIE, Junwen
Shenzhen, Guangdong 518129 (CN)
• MA, Mengyao
Shenzhen, Guangdong 518129 (CN)
• XIAO, Yao
Shenzhen, Guangdong 518129 (CN)
• YANG, Xun
Shenzhen, Guangdong 518129 (CN)

(74) Representative: **Thun, Clemens
Mitscherlich PartmbB
Karlstraße 7
80333 München (DE)**

(54) **DATA COMPRESSION METHOD AND APPARATUS**

(57)     This application relates to the field of communication technologies, and provides a data compression method, and an apparatus, to improve compression efficiency of time series sensing data. The compression method includes: A first apparatus obtains to-be-compressed data (501), where the to-be-compressed data includes position information of a data point and data information corresponding to the data point; performs data compression based on the to-be-compressed data to obtain target coded data (502), where the target coded data includes first information and second information, the first information indicates a type corresponding to the data information in the to-be-compressed data, the type corresponding to the data information includes a non-prediction type and at least one prediction type, and the second information includes data information corresponding to the non-prediction type in the to-be-compressed data; and outputs the target coded data.

FIG. 5

**Description**

**TECHNICAL FIELD**

This application relates to the field of communication technologies, and in particular, to a data compression method, and an apparatus.

**BACKGROUND**

With rapid development of technologies such as wireless communication, autonomous driving, or artificial intelligence, generation, storage, and transmission of a large amount of two-dimensional (two-dimensional, 2D) or three-dimensional (three-dimensional, 3D) data in a communication system are widely applied in various scenarios. For example, in a scenario of map reconstruction and device-cloud interaction in autonomous driving, a terminal may upload consecutively collected sensing data (such as road data and position information) to a network device or a cloud for data processing. A high correlation or redundant information exists between consecutive data frames, and therefore, a temporal correlation-based data compression solution can be designed to save storage resources and improve communication efficiency.

Currently, 3D time series data may be compressed according to a nearest-neighbor point removal algorithm. Specifically, nearest-neighbor search may be performed on points in the current frame based on a historical point cloud set, some nearest-neighbor points are removed based on a specified distance threshold, and then data compression is performed on the remaining points according to a compression algorithm. In this way, compression and transmission of time series sensing data are implemented.

However, this implementation is applicable only to a static scanning scenario or a scenario with few moving objects in an environment. In a dynamic scanning scenario or a scenario with many or complex moving objects in an environment, a quantity of nearest-neighbor points that can be removed is small, resulting in poor data compression performance.

**SUMMARY**

Embodiments of this application provide a data compression method, and an apparatus, to improve compression efficiency of time series sensing data.

To achieve the foregoing objective, this application uses the following technical solutions.

According to a first aspect, a data compression method is provided. The method may be performed by a first apparatus. Unless otherwise specified, the first apparatus in this application may be the first apparatus (for example, a network device or a terminal), or may be a component (for example, a processor, a chip, or a chip system) in the second apparatus, or may be a logical module or software that can implement all or some functions of the first apparatus. The method includes: obtaining to-be-compressed data, where the to-be-compressed data includes position information of a data point and data information corresponding to the data point; performing data compression based on the to-be-compressed data to obtain target coded data, where the target coded data includes first information and second information, the first information indicates a type corresponding to the data information in the to-be-compressed data, the type corresponding to the data information includes a non-prediction type and at least one prediction type, and the second information includes data information corresponding to the non-prediction type in the to-be-compressed data; and outputting the target coded data.

In the foregoing implementation, according to the data compression method based on 2D data structure classification, a classification indication of a data point is designed, a type of the data point is indicated to a decoder side based on first information, different modes are selected for prediction or encoding based on a feature of the data point, and different compression processing is performed on different types of data points. This can effectively improve encoding efficiency and compression performance.

In an implementation, a prediction type corresponding to the data information includes at least one of the following: a first type or a second type. The first type is a data point type of a data point that is in the to-be-compressed data and that meets a time series translation prediction condition, and the second type is a data point type of a data point that is in the to-be-compressed data and that meets a planar prediction condition.

In the foregoing implementation, data points in the to-be-compressed data are classified, for example, a type like translation prediction or planar prediction is included, so that encoding and compression processing can be performed on data points of this prediction type, and a decoder side can perform data recovery based on types of data points in a historical frame and a current frame. In this way, data compression efficiency can be improved.

In an implementation, the non-prediction type corresponding to the data information includes at least one of the following: a third type or a fourth type. The third type is a type of a data point that has data information, and the fourth type is a type of a data point that has data information and that does not meet a condition corresponding to the prediction type.

In the foregoing implementation, data points in the to-be-compressed data are classified, for example, include an empty data point or an unpredictable non-empty data point, so that the encoder side can separately perform encoding and compression processing on such data points of the non-prediction type. In this way, the decoder side can perform data recovery in a corresponding decoding manner, and data compression efficiency can be improved.

In an implementation, the prediction type corresponding to the data information includes a fifth type. The fifth type is a data point type of a data point that is in the to-be-compressed data and that meets a curved surface prediction condition.

In the foregoing implementation, the data points in the to-be-compressed data are classified, and a curved surface prediction type may be further included. Curved surface fitting is performed on a plurality of neighbor points of the historical frame, so that data points on a same curved surface in the current frame can be recovered based on the historical frame. In this way, data compression efficiency can be improved.

In an implementation, the to-be-compressed data includes a first data point, the first data point includes first position information and first data information, and that the first data point meets the time series translation prediction condition includes: obtaining a first prediction value based on original coordinates of a reference point in a historical frame and a translation prediction vector. A distance error between the first prediction value and original coordinates corresponding to the first data point is less than or equal to a first threshold; or a distance error between data information corresponding to the first prediction value in a target coordinate system and the first data information corresponding to the first data point is less than or equal to a second threshold, where position information of the first prediction value in the target coordinate system is the same as the first position information corresponding to the first data point.

In the foregoing implementation, the encoder side may determine, by determining whether the data point meets the foregoing time series translation prediction condition, whether the data point is of a predictable type, to indicate the type of the data point to the decoder side, so that the decoder side can recover data based on the historical frame and the type of the data point, thereby improving data compression efficiency.

In an implementation, the method further includes: obtaining third information, where the third information indicates coordinate information of a reference point corresponding to the first apparatus, and is used to calculate the translation prediction vector based on a position of the reference point in the historical frame and a position of the reference point in a current frame.

In the foregoing implementation, the encoder side or the decoder side may obtain the third information, for example, information about a scanning position, to calculate the translation prediction vector. The decoder side may correctly recover the compressed data based on the translation prediction vector.

In an implementation, the to-be-compressed data includes a second data point, the second data point includes second position information and second data information, and that the second data point meets the planar prediction condition includes: performing fitting processing based on a reference point in a historical frame and a plurality of neighbor points of the reference point to obtain a prediction plane; and obtaining a second prediction value based on the position information corresponding to the second data point and the prediction plane. A distance error between the second prediction value and original coordinates of the second data point is less than or equal to a third threshold; or a distance error between data information corresponding to the second prediction value in a target coordinate system and the second data information corresponding to the second data point is less than or equal to a fourth threshold, where the second prediction value is located on the prediction plane of the historical frame, and position information of the second prediction value in the target coordinate system is the same as the second position information corresponding to the second data point.

In the foregoing implementation, the encoder side may determine, by determining whether the data point meets the foregoing planar prediction condition, whether the data point is of a predictable type, to indicate the type of the data point to the decoder side, so that the decoder side can recover data based on the historical frame and the type corresponding to the data point, thereby improving data compression efficiency.

In an implementation, the method further includes: obtaining first indication information, where the first indication information includes at least one of the following information: an indication of a type used for a data point, a quantity of neighbor points corresponding to planar prediction, an absolute position or an offset position of a neighbor point for planar prediction, a quantization step and a quantization boundary value that correspond to quantization of raw data, or whether block division processing is performed on the to-be-encoded data, and a block size and/or a block sliding direction corresponding to block division processing.

In the foregoing implementation, the encoder side may obtain configuration information or a parameter of an encoding algorithm, to determine a type used for a data point in a data compression algorithm and the like. The first indication information may be sent by the decoder side, that is, the second apparatus, to the first apparatus, or may be configured by another network element, so that the encoder side can align the configuration information or the parameter with the decoder side, and the decoder side can correctly recover the data.

In an implementation, the method further includes: obtaining second indication information indicating that an encoding mode corresponding to the data information of the non-prediction type is performing residual encoding based on a historical frame corresponding to the data information, or performing direct encoding based on the data information.

In the foregoing implementation, the encoder side may obtain the encoding algorithm of the non-prediction type, and the second indication information may be sent by the decoder side, that is, the second apparatus, to the first apparatus, or may be configured by another network element, so that the encoder side can align the encoding algorithm with the decoder side, and the decoder side can correctly recover data.

In an implementation, the second indication information further includes at least one of the following information: the first threshold, the second threshold, the third threshold, the fourth threshold, or indication information of a manner of determining a data point type in the to-be-encoded data.

In the foregoing implementation, the encoder side may further obtain a threshold corresponding to a translation prediction algorithm, a threshold corresponding to a planar prediction algorithm, or a manner of determining the type of the data point in the to-be-encoded data, for example, the type of each data point may be determined in a sequential determining manner or an independent determining manner, to improve data compression efficiency.

In an implementation, the method further includes: determining, based on the first indication information and/or the second indication information, whether the target coded data includes at least one of the following: coded data corresponding to a prediction error value of data information of the first type, coded data corresponding to a prediction error value of data information of the second type, or position information of a plurality of nearest-neighbor points in the historical frame, and/or position information corresponding to data information of the fourth type and offset values of positions of a plurality of nearest-neighbor points in the historical frame, where the nearest-neighbor point is a point that is in the historical frame and that is closest to a data point in the current frame.

In the foregoing implementation, the encoder side may further determine, based on the configured indication information, an encoding mode used for each type of data points, for example, whether direct encoding or residual encoding is performed on a data point of the fourth type, and whether a residual value is encoded for a data point of the prediction type, data included in the target coded data is further determined. The encoder side may align encoding modes corresponding to different types of data points with the decoder side, and may flexibly adjust the encoding algorithm based on a communication requirement, so that the decoder side can correctly recover data, thereby improving data compression performance and flexibility.

In an implementation, obtaining the to-be-compressed data includes: performing coordinate mapping and/or quantization processing on raw data corresponding to an original coordinate system of a current frame, to obtain to-be-encoded data corresponding to a target coordinate system.

In the foregoing implementation, the encoder side may preprocess the raw data, that is, may obtain the to-be-encoded data through coordinate mapping and/or quantization processing. This reduces data complexity, and improves data compression efficiency and compression performance.

In an implementation, the method further includes: determining, for each data point included in the to-be-encoded data, one by one and in descending order of data point type priorities, a type that the data point meets; and obtaining the first information based on the type corresponding to each data point in the to-be-encoded data.

In an implementation, the method includes: obtaining a priority order corresponding to the data point types.

According to a second aspect, a data compression method is provided. The method may be performed by a second apparatus. Unless otherwise specified, the second apparatus in this application may be the second apparatus (for example, a network device or a terminal), or may be a component (for example, a processor, a chip, or a chip system) in the second apparatus, or may be a logical module or software that can implement all or some functions of the second apparatus. The method includes: obtaining target coded data, where the target coded data indicates first information and second information, the first information indicates a type corresponding to data information in to-be-compressed data, the type corresponding to the data information includes a non-prediction type and at least one prediction type, and the second information includes data information corresponding to the non-prediction type in the to-be-compressed data; and decoding the target coded data to obtain the to-be-compressed data, where the to-be-compressed data includes position information corresponding to a data point and data information corresponding to the data point.

In an implementation, a prediction type corresponding to the data information includes at least one of the following: a first type or a second type. The first type is a data point type of a data point that is in the to-be-compressed data and that meets a time series translation prediction condition, and the second type is a data point type of a data point that is in the to-be-compressed data and that meets a planar prediction condition.

In an implementation, the non-prediction type corresponding to the data information includes at least one of the following: a third type or a fourth type. The third type is a type of a data point that has no data information, and the fourth type is a type of a data point that has data information and that does not meet a condition corresponding to the prediction type.

In an implementation, the prediction type corresponding to the data information includes a fifth type. The fifth type is a data point type of a data point that is in the to-be-compressed data and that meets a curved surface prediction condition.

In an implementation, the to-be-compressed data includes a first data point, the first data point includes first position information and first data information, and that the first data point meets the time series translation prediction condition includes: obtaining a first prediction value based on original coordinates of a reference point in a historical frame and a translation prediction vector. A distance error between the first prediction value and original coordinates corresponding to the first data point is less than or equal to a first threshold; or a distance error between data information corresponding to the first prediction value in a target coordinate system and the first data information corresponding to the first data point is less than or equal to a second threshold, where position information of the first prediction value in the target coordinate system is the same as the first position information corresponding to the first data point.

In an implementation, the method further includes: obtaining third information, where the third information indicates coordinate information of a reference point corresponding to the first apparatus, and is used to calculate the translation prediction vector based on a position of the reference point in the historical frame and a position of the reference point in a current frame.

In an implementation, the to-be-compressed data includes a second data point, the second data point includes second position information and second data information, and that the second data point meets the planar prediction condition includes: performing fitting processing based on a reference point in a historical frame and a plurality of neighbor points of the reference point to obtain a prediction plane; and obtaining a second prediction value based on the position information corresponding to the second data point and the prediction plane. A distance error between the second prediction value and original coordinates of the second data point is less than or equal to a third threshold; or a distance error between data information corresponding to the second prediction value in a target coordinate system and the second data information corresponding to the second data point is less than or equal to a fourth threshold, where the second prediction value is located on the prediction plane of the historical frame, and position information of the second prediction value in the target coordinate system is the same as the second position information corresponding to the second data point.

In an implementation, the method further includes: obtaining first indication information, where the first indication information includes at least one of the following information: an indication of a type used for a data point, a quantity of neighbor points corresponding to planar prediction, an absolute position or an offset position of a neighbor point for planar prediction, a quantization step and a quantization boundary value that correspond to quantization of raw data, or whether block division processing is performed on the to-be-encoded data, and a block size and/or a block sliding direction corresponding to block division processing.

In an implementation, decoding the target coded data to obtain the to-be-compressed data includes: obtaining, based on the first information in the target coded data, position information corresponding to each data point and a type corresponding to the data point in the to-be-compressed data; and obtaining, through decoding based on the type of the data point and the second information, data information corresponding to the position information of each data point in the to-be-compressed data, where data information corresponding to a data point of the prediction type is obtained through prediction based on a historical frame, and data information corresponding to a data point of the non-prediction type is obtained based on the second information.

In an implementation, the method further includes: obtaining second indication information indicating that an encoding mode corresponding to the data information of the non-prediction type is performing residual encoding based on a historical frame corresponding to the data information, or performing direct encoding based on the data information.

In an implementation, the second indication information further includes at least one of the following information: the first threshold, the second threshold, the third threshold, the fourth threshold, or indication information of a manner of determining a data point type in the to-be-encoded data.

In an implementation, the method further includes: determining, based on the first indication information and/or the second indication information, whether the target coded data includes at least one of the following: coded data corresponding to a prediction error value of data information of the first type, coded data corresponding to a prediction error value of data information of the second type, or position information of a plurality of nearest-neighbor points in the historical frame, and/or position information corresponding to data information of the fourth type and offset values of positions of a plurality of nearest-neighbor points in the historical frame, where the nearest-neighbor point is a point that is in the historical frame and that is closest to a data point in the current frame.

In an implementation, the method further includes: performing coordinate mapping and/or dequantization processing on the to-be-compressed data corresponding to a target coordinate system, to obtain recovered data corresponding to an original coordinate system.

According to a third aspect, a communication apparatus is provided. The communication apparatus may be the first apparatus in the first aspect, or an apparatus including the encoding function, or a module in the first apparatus in the first aspect, for example, a chip, a chip system, or a circuit, or a logical node, a logical module, or software that can implement a part or all of encoding functions.

Alternatively, the communication apparatus may be the second apparatus in the second aspect, or an apparatus including the decoding function, or a module in the second apparatus in the second aspect, for example, a chip, a chip system, or a circuit, or a logical node, a logical module, or software that can implement a part or all of decoding functions.

The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

With reference to the third aspect, in a possible implementation, the communication apparatus may include a processing module and a transceiver module. The processing module may be configured to implement a processing function in any one of the foregoing aspects and the possible implementations of the foregoing aspects. The processing module may be, for example, a processor. The transceiver module may also be referred to as a transceiver unit, and is configured to implement a sending function and/or a receiving function in any one of the foregoing aspects and the possible implementations of the foregoing aspects. The transceiver module may include a transceiver circuit, a transceiver machine, a transceiver, or a communication interface.

With reference to the third aspect, in a possible implementation, the transceiver module includes a sending module and a receiving module, which are respectively configured to implement the sending function and the receiving function in any one of the foregoing aspects and the possible implementations of the foregoing aspects.

According to a fourth aspect, a communication apparatus is provided, and includes a processor. The processor is configured to: be coupled to a memory, and after reading instructions in the memory, perform the method according to any one of the foregoing aspects based on the instructions. The communication apparatus may be the encoder side in any one of the first aspect and the possible implementations of the first aspect, or an apparatus including the encoding function, or a module in the encoder side, for example, a chip, a chip system, or a circuit, or a logical node, a logical module, or software that can implement a part or all of encoding functions.

Alternatively, the communication apparatus may be the decoder side in any one of the second aspect and the possible implementations of the second aspect, or an apparatus including the decoding function, or a module in the decoder side, for example, a chip, a chip system, or a circuit, or a logical node, a logical module, or software that can implement a part or all of decoding functions.

With reference to the fourth aspect, in a possible implementation, the communication apparatus further includes a memory. The memory is configured to store necessary program instructions and data.

With reference to the fourth aspect, in a possible implementation, the communication apparatus is a chip or a chip system. Optionally, when the communication apparatus is the chip system, the communication apparatus may include a chip, or may include a chip and another discrete device.

According to a fifth aspect, a communication apparatus is provided, and includes a processor and an interface circuit. The interface circuit is configured to: receive a computer program or instructions, and transmit the computer program or the instructions to the processor. The processor is configured to execute the computer program or the instructions, to enable the communication apparatus to perform the method according to any one of the foregoing aspects. The communication apparatus may be the encoder side in any one of the first aspect and the possible implementations of the first aspect, or an apparatus including the encoding function, or a module in the encoder side, for example, a chip, a chip system, or a circuit, or a logical node, a logical module, or software that can implement a part or all of encoding functions.

Alternatively, the communication apparatus may be the decoder side in any one of the second aspect and the possible implementations of the second aspect, or an apparatus including the decoding function, or a module in the decoder side, for example, a chip, a chip system, or a circuit, or a logical node, a logical module, or software that can implement a part or all of decoding functions.

With reference to the fifth aspect, in a possible implementation, the communication apparatus is a chip or a chip system. Optionally, when the communication apparatus is the chip system, the communication apparatus may include a chip, or may include a chip and another discrete device.

According to a sixth aspect, a computer-readable storage medium is provided. The computer-readable storage medium stores instructions, and when the instructions are run on a computer, the computer is enabled to perform the method according to any one of the foregoing aspects.

According to a seventh aspect, a computer program product including instructions is provided. When the computer program product runs on a computer, the computer is enabled to perform the method according to any one of the foregoing aspects.

According to an eighth aspect, a communication system is provided. The communication system includes a communication apparatus configured to perform the method in any one of the first aspect and the possible implementations of the first aspect, and a communication apparatus configured to perform the method in any one of the second aspect and the possible implementations of the second aspect.

For technical effect brought by any one of the possible implementations of the second aspect to the eighth aspect, refer to technical effect brought by the different possible implementations of the first aspect. Details are not described herein again.

It may be understood that the solutions in the foregoing aspects may be combined if the solutions are not contradictory.

## BRIEF DESCRIPTION OF DRAWINGS

FIG. 1 is an interaction diagram of data compression and transmission;

FIG. 2 is a diagram of a data compression algorithm;

FIG. 3 is a diagram of a structure of a communication system according to an embodiment of this application;

FIG. 4 is a diagram of a structure of a communication apparatus according to an embodiment of this application;

FIG. 5 is a schematic flowchart of a data compression method according to an embodiment of this application;

FIG. 6 is a diagram of coordinate mapping according to an embodiment of this application;

FIG. 7 is a diagram of a 2D data structure obtained according to a data compression algorithm according to an embodiment of this application;

FIG. 8 is a diagram of data points that meet a time series translation prediction condition according to an embodiment of this application;

FIG. 9 is a diagram of data points that meet a planar prediction condition according to an embodiment of this application;

FIG. 10 is a diagram of a 2D type graph obtained according to a data compression algorithm according to an embodiment of this application;

FIG. 11 is a diagram of determining a data point type in to-be-encoded data according to an embodiment of this application;

FIG. 12 is a diagram of a process in which an encoder side determines a plane and resolves a prediction point according to an embodiment of this application;

FIG. 13 is a diagram of block division processing performed by an encoder side according to an embodiment of this application;

FIG. 14 is a diagram of first indication information according to an embodiment of this application;

FIG. 15 is a schematic flowchart of determining a data point type by an encoder side and a decoder side according to an embodiment of this application;

FIG. 16 is a diagram of an encoding mode of data information of a data point of a fourth type according to an embodiment of this application;

FIG. 17 is a diagram of a structure of target coded data according to an embodiment of this application;

FIG. 18 is an interaction diagram of a data compression algorithm according to an embodiment of this application;

FIG. 19 is a simulation diagram of performance of a plurality of data compression algorithms according to an embodiment of this application; and

FIG. 20 is a diagram of a communication apparatus according to an embodiment of this application.

## DESCRIPTION OF EMBODIMENTS

The following describes technical solutions in embodiments of this application with reference to accompanying drawings in embodiments of this application. It is clear that the described embodiments are only a part rather than all of embodiments of this application.

First, an implementation background of this application is described with reference to the accompanying drawings.

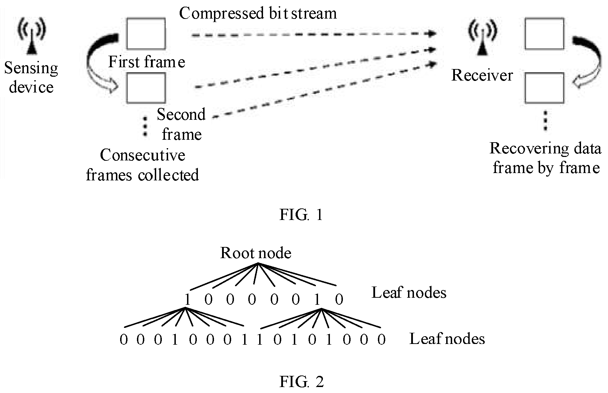

Due to rapid development of technologies such as wireless communication, autonomous driving, and artificial intelligence, a large amount of 2D or 3D data is generated in a communication system. For example, a sensor or a sensing apparatus of a vehicle-mounted terminal may collect road data, and an augmented reality (Augmented Reality, AR) device may collect ambient environment data, the collected 2D or 3D data may be collectively referred to as sensing data, and the sensing data may include 2D or 3D data points related to information such as a distance, a color, and a normal line. An embodiment of this application provides an implementation method for sensing data compression and encoding. As shown in FIG. 1, a sensing device is configured to: collect sensing data to obtain consecutive frames, including a first frame, a second frame, and the like; perform encoding and compression frame by frame according to a configured encoding algorithm; generate a compressed bit stream; and transmit the compressed bit stream to a receiver, for example, the receiver may be a base station. Therefore, the receiver may perform decoding frame by frame according to the configured decoding algorithm, to recover data.

The sensing data collection method may include static scanning, dynamic scanning, and the like. Static scanning is a scenario in which a scanning device does not move, and a moving position, a moving trajectory, and the like of an object in the scenario may be collected through continuous scanning. Dynamic scanning refers to the scenario in which the scanning device moves. For example, if the vehicle-mounted terminal may collect sensing data in a moving process, a current frame may collect data that is blocked, blind spots, or not scanned in a historical frame (for example, a previous frame or previous n frames), to improve map construction and interaction processing performance. However, a difference between data collected by neighbor frames (or historical frames) may be large. Consequently, complexity of time series sensing data compression is also high.

In embodiments of this application, an encoding and decoding process may be performed frame by frame. Therefore, the current frame may indicate a frame on which encoding and decoding processing is performed by the encoder side or the decoder side at a current moment, and a historical frame indicates a frame processed before the current moment. For example, a frame processed at a previous moment may be referred to as a previous frame, frames processed at the previous n moments may be referred to as previous n frames, neighbor frames of the current frame may include a previous frame and a next frame, and the next frame is a frame processed at a moment after the current moment. This is not described again in the following.

Currently, there is a time series point cloud data compression algorithm based on 3D data nearest-neighbor point removal, which specifically includes: The encoder side search for a nearest-neighbor point of each point cloud in the current frame based on a point cloud set in a historical frame, removes some nearest-neighbor points based on a specified distance threshold, and then compresses and transmits the remaining points in a manner such as an octree or Draco. The octree is a data structure based on space division. The encoder side may divide a three-dimensional space into eight subspaces, and further divide each subspace into eight subspaces. In this way, progressive division is performed, and each subspace includes a part of point cloud data in the space. For example, as shown in FIG. 2, each subspace serving as a leaf node may be encoded by using 0 or 1, the encoder side converts each subspace into a coding block, and finally, the encoded octree data may be compressed for storage or transmission, for example, a common compression method such as Huffman coding may be used.

However, this implementation is applicable to a static scanning scenario or a scenario with few moving objects in an environment. In a dynamic scanning scenario or a scenario with many or complex moving objects in an environment, a quantity of nearest-neighbor points that can be removed is small, resulting in poor data compression performance.

This application provides a data compression method, and an apparatus. Based on a compression method for converting 3D data into a 2D structure, a compression rate of sensing data can be effectively improved based on a temporal correlation of 2D data. For example, in a static scanning scenario, after converting 3D sensing data into a 2D structure, an encoder side may calculate a residual for a neighbor frame based on a same position in the 2D structure, and then perform compression through entropy encoding, so that redundant information in a time series can be effectively removed, thereby obtaining a large compression gain. In addition, in a dynamic scanning scenario, due to movement of a scanning position, same positions of a previous frame and a next frame in a 2D structure cannot be mapped to a same point in 3D space, a direct residual cannot obtain a large compression gain, and a plurality of prediction algorithms based on a 2D structure may be used to improve compression performance in a dynamic scenario.

The following describes implementations of this application in detail with reference to accompanying drawings.

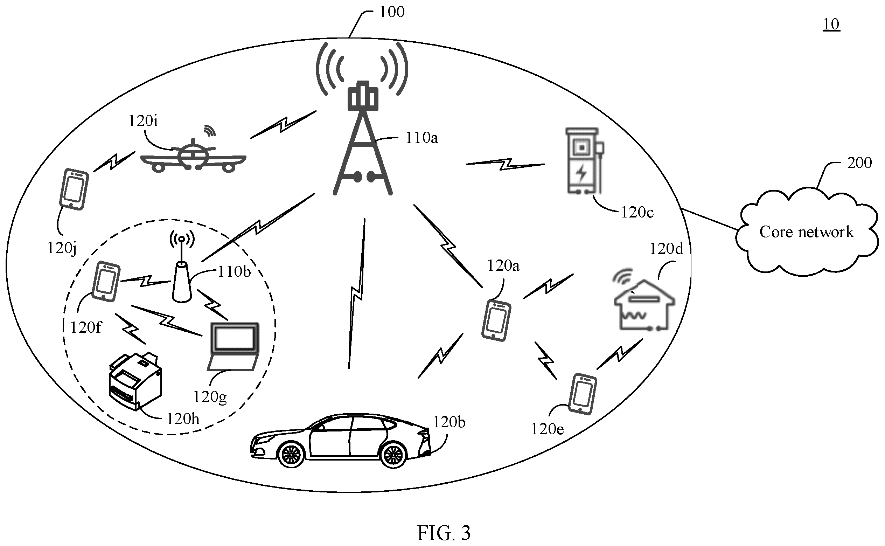

A method provided in this application may be applied to various communication systems. The following uses a communication system 10 shown in FIG. 3 as an example to describe the methods provided in embodiments of this application. FIG. 2 is merely a diagram, and does not constitute a limitation on an application scenario of the technical solutions provided in this application.

FIG. 3 is a diagram of a possible and non-limiting system. As shown in FIG. 3, a communication system 10 includes a RAN 100 and a core network (core network, CN) 200. The RAN 100 includes at least one RAN node (for example, 110a and 110b in FIG. 3, which are collectively referred to as 110) and at least one terminal (for example, 120a to 120j in FIG. 3, which are collectively referred to as 120). The RAN 100 may further include another RAN node, for example, a wireless relay device and/or a wireless backhaul device (not shown in FIG. 3). The terminal 120 is connected to the RAN node 110 in a wireless manner. The RAN node 110 is connected to the core network 200 in a wireless or wired manner. A core network device in the core network 200 and the RAN node 110 in the RAN 100 may respectively be different physical devices, or may be a same physical device that integrates a logical function of the core network and a logical function of the radio access network.

The RAN 100 may be a cellular system related to the 3rd generation partnership project (3rd generation partnership project, 3GPP), for example, a 4G mobile communication system, a 5G mobile communication system, or a future-oriented evolved system (for example, a 6G mobile communication system). The RAN 100 may alternatively be an open access network (open RAN, O-RAN or ORAN), a cloud radio access network (cloud radio access network, CRAN), or a wireless fidelity (wireless fidelity, Wi-Fi) system. The RAN 100 may alternatively be a communication system that integrates the foregoing two or more systems.

The RAN node 110 may also be referred to as an access network device, a RAN entity, a network device, an access node, or the like sometimes, and forms a part of the communication system, to help the terminal implement radio access. A plurality of RAN nodes 110 in the communication system 10 may be nodes of a same type, or may be nodes of different types. In some scenarios, roles of the RAN node 110 and the terminal 120 are relative. For example, the network element 120i in FIG. 3 may be a helicopter or an uncrewed aerial vehicle, and may be configured as a mobile base station. For terminals 120j that access the RAN 100 via the network element 120i, the network element 120i is a base station.

However, for the base station 110a, the network element 120i is a terminal. The RAN node 110 and the terminal 120 are both referred to as communication apparatuses sometimes. For example, 110a and 110b in FIG. 3 may be understood as communication apparatuses having a base station function, and the network elements 120a to 120j may be understood as communication apparatuses having a terminal function.

In a possible scenario, the RAN node may be a base station (base station), an evolved NodeB (evolved NodeB, eNodeB), an access point (access point, AP), a transmission reception point (transmission reception point, TRP), a next generation NodeB (next generation NodeB, gNB), a next generation base station in a 6th generation (6th generation, 6G) mobile communication system, a base station in a future mobile communication system, an access node in a Wi-Fi system, or the like. The RAN node may be a macro base station (for example, 110a in FIG. 3), a micro base station or an indoor station (for example, 110b in FIG. 3), a relay node or a donor node, or a radio controller in a CRAN scenario. Optionally, the RAN node may alternatively be a server, a wearable device, a vehicle, a vehicle-mounted device, or the like. For example, an access network device in a vehicle to everything (vehicle to everything, V2X) technology may be a road side unit (road side unit, RSU). All or a part of functions of the RAN node in this application may alternatively be implemented by using a software function running on hardware, or may be implemented by using a virtualization function instantiated on a platform (for example, a cloud platform). Alternatively, the RAN node in this application may be a logical node, a logical module, or software that can implement all or a part of functions of the RAN node.

In another possible scenario, a plurality of RAN nodes collaborate to assist the terminal in implementing radio access, and different RAN nodes respectively implement some functions of the base station. For example, the RAN node may be a central unit (central unit, CU), a DU, a CU-control plane (control plane, CP), a CU-user plane (user plane, UP), or an RU. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may alternatively have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any unit of the CU (or the CU-CP or the CU-UP), the DU, and the RU in this application may be implemented by using a software module, a hardware module, or a combination of a software module and a hardware module.

The terminal may alternatively be referred to as a terminal device, user equipment (user equipment, UE), a mobile station, a mobile terminal, or the like. The terminal may be widely used in various scenarios, for example, device-to-device (device-to-device, D2D), vehicle-to-everything (vehicle-to-everything, V2X) communication, machine-type communication (machine-type communication, MTC), internet of things (internet of things, IoT), virtual reality, augmented reality, industrial control, autonomous driving, telemedicine, a smart grid, smart furniture, a smart office, smart wearable, smart transportation, and a smart city. The terminal may be a mobile phone, a tablet computer, a computer having a wireless transceiver function, a wearable device, a vehicle, an uncrewed aerial vehicle, a helicopter, an airplane, a ship, a robot, a mechanical arm, a smart home device, or the like. A device form of the terminal is not limited in embodiments of this application.

The terminal may alternatively be a virtual reality (virtual reality, VR) terminal, an AR terminal, or a mixed reality (mixed reality, MR) terminal. The VR terminal, the AR terminal, and the MR terminal may all be referred to as extended reality (extended reality) terminals. The XR terminal may be, for example, a head-mounted device (for example, a helmet, a head-mounted display (head-mounted display, HMD), or glasses), may be an all-in-one machine, or may be a television, a display, a car, a vehicle-mounted device, a tablet, or a smart screen. The XR terminal may access a network in a wireless or wired manner, for example, access the network through a Wi-Fi or 5G system. The XR terminal can present XR data to a user, and the user can experience diversified XR services by wearing or using the XR terminal.

The communication system 10 shown in FIG. 3 is merely used as an example, but is not intended to limit the technical solutions of this application. A person skilled in the art should understand that, in a specific implementation process, the communication system 10 may further include another device, and a quantity of RAN nodes and a quantity of terminals may alternatively be determined based on a specific requirement. This is not limited.

Optionally, each network element or device (for example, the RAN node or the terminal) in FIG. 3 in this application may also be referred to as a communication apparatus, and may be a general-purpose device or a dedicated device. This is not specifically limited in this application.

Optionally, related functions of each network element or device (for example, the RAN node or the terminal) in FIG. 3 in this application may be implemented by one device, or may be jointly implemented by a plurality of devices, or may be implemented by one or more functional modules in one device. This is not specifically limited in this application. It may be understood that the foregoing function may be a network element in a hardware device, or may be a software function running on dedicated hardware, or a combination of hardware and software, or an instantiated virtualized function on a platform (for example, a cloud platform).

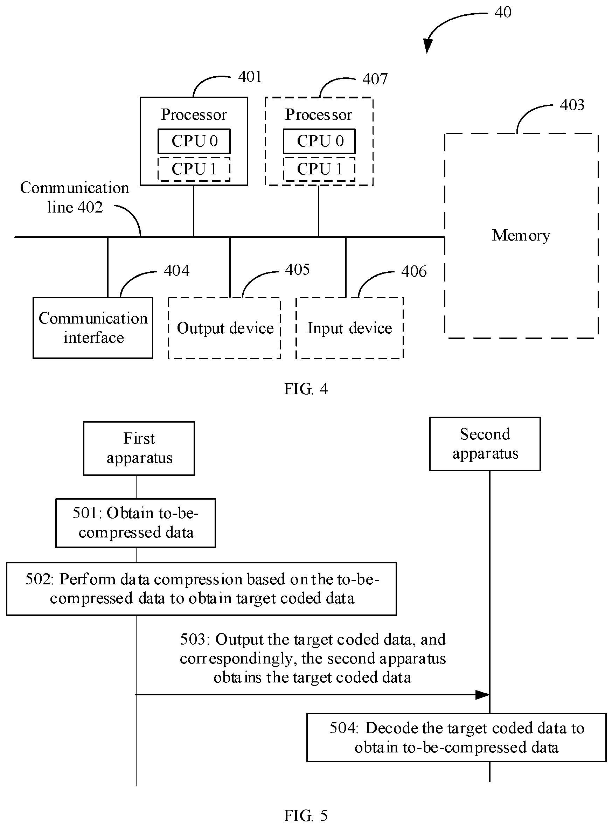

In a specific implementation, each network element or device (for example, the RAN node or the terminal) in FIG. 3 in this application may use a composition structure shown in FIG. 4, or include components shown in FIG. 4. FIG. 4 is a diagram of a hardware structure of a communication apparatus to which this application is applicable. The communication apparatus 40 includes at least one processor 401 and at least one communication interface 404, to implement the method provided in this application. The communication apparatus 40 may further include a communication line 402 and a memory 403.

The processor 401 may be a general-purpose central processing unit (central processing unit, CPU), a microprocessor, an application-specific integrated circuit (application-specific integrated circuit, ASIC), or one or more integrated circuits configured to control execution of solution programs of this application.

The communication line 402 may include a path, such as a bus, for transferring information between the components described above.

The communication interface 404 is configured to communicate with another device or a communication network. The communication interface 404 may be any apparatus such as a transceiver, for example, may be an Ethernet interface, a radio access network (radio access network, RAN) interface, a wireless local area network (wireless local area network, WLAN) interface, a transceiver, a pin, a bus, or a transceiver circuit.

The memory 403 may be a read-only memory (read-only memory, ROM), another type of static storage device that can store static information and instructions, a random access memory (random access memory, RAM), or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, and the like), or a magnetic disk storage medium or another magnetic storage device, or any other medium that can be configured to carry or store expected program code in a form of instructions or a data structure and that is accessible by a computer, but is not limited thereto. The memory may exist independently, and is coupled to the processor 401 through the communication line 402. Alternatively, the memory 403 may be integrated with the processor 401. Usually, the memory provided in this application may be non-volatile.

The memory 403 is configured to store computer-executable instructions for performing the solutions provided in this application, and the processor 401 controls execution of the computer-executable instructions. The processor 401 is configured to execute the computer-executable instructions stored in the memory 403, to implement the method provided in this application. Alternatively, optionally, in this application, the processor 401 may perform functions related to processing in a method provided in the following embodiments of this application, and the communication interface 404 is responsible for communication with another device or a communication network. This is not specifically limited in this application.

Optionally, the computer-executable instructions in this application may also be referred to as application program code. This is not specifically limited in this application.

The coupling in this application may be an indirect coupling or a communication connection between apparatuses, units, or modules in an electrical form, a mechanical form, or another form, and is used for information exchange between the apparatuses, the units, or the modules.

In an embodiment, the processor 401 may include one or more CPUs, for example, a CPU 0 and a CPU 1 in FIG. 4.

In an embodiment, the communication apparatus 40 may include a plurality of processors, for example, the processor 401 and a processor 407 in FIG. 4. Each of the processors may be a single-core (single-CPU) processor, or may be a multi-core (multi-CPU) processor. The processor herein may be one or more devices, circuits, and/or processing cores configured to process data (for example, computer program instructions).

In an embodiment, the communication apparatus 40 may further include an output device 405 and/or an input device 406. The output device 405 is coupled to the processor 401, and may output/input information in a plurality of manners. For example, the output device 405/input device 406 may be an I/O interface, and the output device 405 may be a liquid crystal display (liquid crystal display, LCD), a light emitting diode (light emitting diode, LED) display device, a cathode ray tube (cathode ray tube, CRT) display device, a projector (projector), or the like. The input device 406 is coupled to the processor 401, and may receive a user input in a plurality of manners. For example, the input device 406 may be a mouse, a keyboard, a touchscreen device, or a sensor device.

It may be understood that the composition structure shown in FIG. 4 does not constitute a limitation on the communication apparatus. In addition to the components shown in FIG. 4, the communication apparatus may include more or fewer components than those shown in the figure, or a combination of a part of the components, or an arrangement of different components.

The following describes the method provided in this application with reference to the accompanying drawings. Network elements in the following embodiments may have some or all components shown in FIG. 4. Details are not described again.

It may be understood that names of messages between network elements, names of parameters in messages, or the like in the following embodiments of this application are merely examples, and there may alternatively be other names during specific implementation. This is not specifically limited in this application.

It may be understood that, in this application, "/" may represent an "or" relationship between associated objects. For example, A/B may represent A or B. The term "and/or" may be used to describe three relationships that exist between associated objects. For example, A and/or B may represent the following three cases: Only A exists, both A and B exist, and only B exists, where A and B may be singular or plural. In addition, a representation similar to "at least one of A, B, and C" or "at least one of A, B, or C" is usually used to represent any one of the following: Only A exists; only B exists; only C exists; both A and B exist; both A and C exist; both B and C exist; and A, B, and C all exist. The foregoing uses three elements A, B, and C as an example to describe an optional item of the project. When there are more elements in the representation, a meaning of the representation may be obtained according to the foregoing rules.

For ease of description of technical solutions of this application, in this application, terms such as "first" and "second" may be used to distinguish between technical features with same or similar functions. Terms such as "first" and "second" do not limit a quantity and an execution order, and the terms such as "first" and "second" do not indicate a definite difference. In this application, a term such as "example" or "for example" indicates an example, an illustration, or a description. Any embodiment or design scheme described as an "example" or "for example" should not be explained as being more preferred or having more advantages than another embodiment or design scheme. Use of the terms such as "example" or "for example" is intended to present a related concept in a specific manner for ease of understanding.

It can be understood that an "embodiment" mentioned throughout this specification means that particular features, structures, or characteristics related to the embodiment are included in at least one embodiment of this application. Therefore, embodiments in the entire specification are necessarily a same embodiment. In addition, these particular features, structures, or characteristics may be combined in one or more embodiments in any appropriate manner. It may be understood that sequence numbers of processes do not mean execution orders in various embodiments of this application. The execution orders of the processes should be determined based on functions and internal logic of the processes, and should not be construed as any limitation on implementation processes of this application.

It can be understood that, in this application, both "when" and "if" mean that corresponding processing is performed in an objective case, but are not intended to limit time. In addition, the terms do not necessarily mean that a determining action is performed during implementation, and do not mean another limitation either.

"Simultaneously" in this application may be understood as being at a same time point, may be understood as being in a period of time, or may be understood as being in a same periodicity.

It may be understood that in some scenarios, some optional features in this application may be independently implemented without depending on other features, for example, a solution on which the optional features are currently based, to resolve a corresponding technical problem and achieve corresponding effects. Alternatively, in some scenarios, the optional features may be combined with other features based on a requirement. Correspondingly, an apparatus provided in this application may also correspondingly implement these features or functions. Details are not described herein.

It may be understood that, in this application, a same step, or steps or technical features that have a same function may be mutually referenced between different embodiments.

It may be understood that, in this application, a RAN node and/or a terminal may perform some or all steps in this application. These steps are merely examples. In this application, other steps or variations of various steps may alternatively be performed. In addition, the steps may be performed in an order different from an order shown in this application, and not all of the steps in this application are necessarily performed.

In this application, the RAN node may further have different expressions, for example, a network device. In this application, unless otherwise specified, a network device is used for description below. The network device is an original expression of an access network device (for example, a base station).

The data compression method in this application may be interactively performed by a first apparatus and a second apparatus. Unless otherwise specified, the first apparatus in this application may be the first apparatus (for example, a network device or a terminal), or may be a component (for example, a processor, an encoder, a chip, or a chip system) in the first apparatus, or may be a logical module or software that can implement all or some functions of the first apparatus. Similarly, the second apparatus in this application may be the second apparatus (for example, a network device or a terminal), or may be a component (for example, a processor, a decoder, a chip, or a chip system) in the second apparatus, or may be a logical module or software that can implement all or some functions of the second apparatus.

It may be understood that "sending information (for example, first configuration information) to (for example, a terminal)" in this application may be understood as that a destination end of the information is the terminal, and may include directly or indirectly sending the information to the terminal. "Receiving information (for example, first indication information) from (for example, a terminal)" may be understood as that a source end of the information is the terminal, and may include directly or indirectly receiving information from the terminal. Information may undergo necessary processing, for example, a format change, between the source end for sending the information and the destination end. However, the destination end may understand valid information from the source end. Similar descriptions in this application may be construed in a similar manner, and details are not described herein again.

It may be understood that "sending information (for example, the first indication information) to (for example, the network device)" in this application may be understood as that a destination end of the information is the network device, and may include directly or indirectly sending the information to the network device. "Receiving information (for example, first configuration information) from (for example, a network device)" may be understood as that a source end of the information is the network device, and may include directly or indirectly receiving information from the network device. Information may undergo necessary processing, for example, a format change, between the source end for sending the information and the destination end. However, the destination end may understand valid information from the source end. Similar descriptions in this application may be construed in a similar manner, and details are not described herein again.

It may be understood that, in the method provided below in this application, the method is illustrated by using an example in which the network device and the terminal are used as execution bodies of interaction illustration. However, the execution bodies of the interaction illustration are not limited in this application. For example, the method performed by the network device in this application may alternatively be performed by a module (for example, a chip, a chip system, or a processor) of the network device, or may be implemented by a logical node, a logical module, or software that can implement all or some functions of the network device. The method performed by the terminal in this application may alternatively be performed by a module (for example, a chip, a chip system, or a processor) of the terminal, or may be implemented by a logical node, a logical module, or software that can implement all or some functions of the terminal.

This application provides a data compression method. For example, the method may be applied to a first apparatus and a second apparatus. The first apparatus or the second apparatus may be any node in the communication system shown in FIG. 3, or a module, a chip, or the like in the node. The first apparatus may be used as an encoder side to encode and compress time series sensing data, and the second apparatus may be used as a decoder side to decode and recover the data.

As shown in FIG. 5, the method may include the following steps.

501: The first apparatus obtains to-be-compressed data.

The first apparatus may be used as a scanning apparatus to collect sensing data, and the collected sensing data is used as the to-be-compressed data or preprocessed sensing data is used as the to-be-compressed data. Alternatively, the first apparatus may obtain the to-be-compressed data from another apparatus. This is not limited in this application.

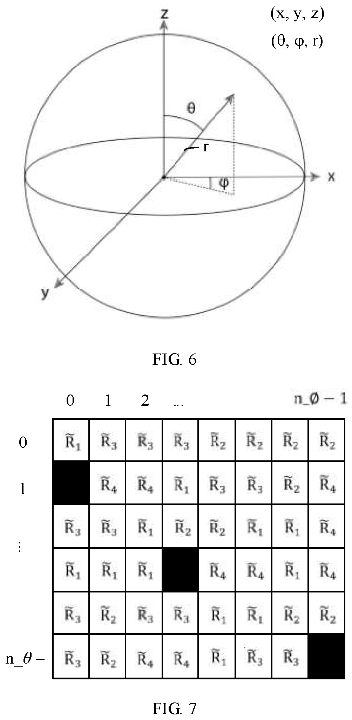

For example, the to-be-compressed data may be shown in FIG. 6. Raw data collected by a sensing device is data based on a spherical coordinate system, and is represented as three-dimensional data by using a vertical angle $\theta$, a horizontal angle $\varphi$, and a distance r from a point to an origin. Alternatively, the to-be-compressed data may be data based on a Cartesian coordinate system, and is represented by using three-dimensional coordinates (x, y, z) corresponding to an X axis, a Y axis, and a Z axis. A coordinate system used for the to-be-compressed data is not specifically limited in this application.

The to-be-compressed data may include position information and data information corresponding to the position information. The position information may indicate a corresponding position of the data information in the to-be-compressed data (for example, may be a 2D or 3D data structure), and is not limited to indicating a position in a spatial scenario.

In other words, the encoder side may distinguish the to-be-compressed data into the position information indicating the position and the data information corresponding to the position information, so that the encoder side can separately encode and compress the data information in the to-be-compressed data subsequently. For example, the encoder side may use two-dimensional data in the 3D data as position information, and use third-dimensional data as data information at the position, to design and obtain a 2D data structure diagram, and indicate a position of a data point in the 2D data structure diagram.

For example, the encoder side may use the vertical angle $\theta$ and the horizontal angle $\varphi$ in the spherical coordinate system as the position information, and use the corresponding distance value r as the data information; or the encoder side may use the vertical angle $\theta$ and the distance value r in the spherical coordinate system as the position information, and use the corresponding horizontal angle $\varphi$ as the data information. For another example, the encoder side may use values of the X axis and the Y axis in the Cartesian coordinate system as the position information, and use a value of the Z axis as the data information.

In an implementation, step 501 may specifically include the following process: The first apparatus performs coordinate mapping and/or quantization processing on raw data corresponding to an original coordinate system of a current frame, to obtain to-be-encoded data corresponding to a target coordinate system.

The coordinate mapping may be specifically a process of mapping the sensing data from the original coordinate system to the target coordinate system. For example, for the raw data collected by the sensing device based on the three-dimensional data in the Cartesian coordinate system, coordinate mapping may be performed according to a mapping algorithm from the Cartesian coordinate system to the spherical coordinate system, to obtain the to-be-encoded data based on the spherical coordinate system.

For example, the mapping algorithm from the Cartesian coordinate system to the spherical coordinate system may satisfy the following formula:

$$\theta = \arcsin\left(z / \sqrt{x^2 + y^2 + z^2}\right), \emptyset = \arccos\left(x / \sqrt{x^2 + y^2}\right), \text{ and } r = \sqrt{x^2 + y^2 + z^2}.$$

It should be noted that the original coordinate system or the target coordinate system is not specifically limited in this application. For example, the target coordinate system may be a spherical coordinate system, a cylindrical coordinate system, or the like.

In addition, quantization processing is a process of approximating consecutive values (or a large quantity of possible discrete values) of data to a limited quantity of (or a small quantity of) discrete values based on a specific quantization step. For example, the first apparatus may select a quantization step to separately quantize data in each dimension. For example, the first apparatus may quantize the vertical angle $\theta$ based on a quantization step of 1°, may quantize the vertical angle $\theta$ ranging from 0° to 1° as 0, quantize the vertical angle $\theta$ ranging from 1° to 2° as 1, quantize the vertical angle $\theta$ ranging from 2° to 3° as 2, and so on. In this case, for a vertical angle $\theta$ ranging from 0° to 180° in the spherical coordinate system, the vertical angle may be quantized to 180 discrete values (0, 1, 2, 3, 4, 5, ..., 179) based on the quantization step, and the angle values 0° and 180° may be quantization boundary values. The horizontal angle $\varphi$ or the distance value r may be quantized according to a similar quantization algorithm. A quantization step and a quantization boundary value corresponding to each coordinate may be determined based on a configured quantization parameter. This is not specifically limited in this application.

For example, the first apparatus may obtain of a 2D data structure diagram shown in FIG. 7 based on mapping processing and/or quantization processing of the foregoing spherical coordinates. Each block in the 2D data structure diagram represents one data point, each data point corresponds to two-dimensional position information, and each data point corresponds to data information. The data information may be information about a distance from a point to a scanning position, or may be a projection distance $\sqrt{x^2 + y^2}$ of a point on an XOY plane, or the like. This is not limited in this application. As shown in FIG. 7, an R value padded in each data point indicates data information corresponding to the data point. In the 2D data structure diagram, some two-dimensional positions may have no corresponding data information. In this case, the padding value herein is null.

502: The first apparatus performs data compression based on the to-be-compressed data to obtain target coded data.

503: The first apparatus outputs the target coded data, and correspondingly, the second apparatus obtains the target coded data.

The target coded data includes first information and second information, the first information indicates a type corresponding to data information in the to-be-compressed data, the type corresponding to the data information includes a non-prediction type and at least one prediction type, and the second information includes data information corresponding to the non-prediction type in the to-be-compressed data.

In other words, in this embodiment of this application, the data points in the obtained 2D data structure diagram are classified to obtain a type corresponding to each data point (or each piece of data information, including a data point whose data information is empty). Then, the first apparatus may generate the first information based on the type of each data point, and sent the first information to the second apparatus. In addition, in this embodiment of this application, after the 2D data structure diagram is obtained, the second information may be generated based on the data information corresponding to the data point in the 2D data structure diagram, and sent to the second apparatus.

Specifically, a method for classifying data points may include: For example, the first apparatus may classify each data point (that is, each piece of data information, including a data point whose data information is empty) into a prediction type and a non-prediction type according to whether a data point in a current frame can be predicted based on a data point in a historical frame. Further, optionally, the type of the data point may further include at least one prediction type like a first type and/or a second type for performing prediction according to different prediction algorithms.

In this application, based on the foregoing data point classification method, the first apparatus may select, based on different types of data points, different encoding modes for filtering or encoding, so that compression performance can be improved. For example, the encoder side may filter out a data point of a prediction type, that is, data information corresponding to the data point of the prediction type does not need to be encoded. The decoder side determines that the data point is of the prediction type, and may predict the data point in the current frame according to a prediction algorithm and a data point recovered from a historical frame.

In an implementation, the prediction type corresponding to the data information may include a first type. The first type is a data point type of a data point that is in the to-be-compressed data and that meets a time series translation prediction condition. The translation prediction may also be understood as line prediction. To be specific, in a scenario in which a scanning position moves or is still, a position of a point in the historical frame corresponds to a point in the current frame after translation motion, or a scanning position of the historical frame corresponds to a scanning position of the current frame after translation motion. In this case, in an encoding and decoding process, the feature may be used to obtain the coordinate information or the data information of the point in the current frame through prediction based on the coordinate information or the data information of the point in the historical frame.

Specifically, the first apparatus may determine, according to the following method, that a data point meets a time series translation condition.

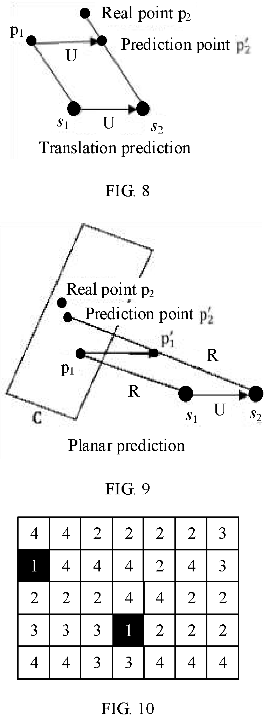

For example, as shown in FIG. 8, the scanning position in the historical frame is $s_1$, the scanning position in the current frame is $s_2$, and a movement vector corresponding to the scanning position in the current frame may be $\vec{U}$. In the 2D data structure diagram, 3D coordinate points of two neighbor frames at a same position are $p_1$ and $p_2$. Coordinates of $p_1$ may be obtained by the decoder side through prediction, or may be fed back by the encoder side to the decoder side for predicting recovered data.

Then, the first apparatus may obtain a prediction value $p_2'$ through prediction based on $\overrightarrow{p_1 + U}$. Based on a configured translation prediction threshold t1, the first apparatus determines an error value between the prediction value and a real value of the point, for example, if the error value $\|\overrightarrow{p_2 - (p_1 + U)}\| \leq t1$, and may determine that the point meets a time series translation condition, a prediction coordinate of $p_2$ may be recovered by the decoder side according to $\overrightarrow{p_1 + U}(p_1 + U)$ is $p_2'$ .

It should be noted that, if coordinate mapping processing is performed on the to-be-compressed data, the first apparatus may determine, based on original coordinates of the sensing data or current coordinates of the to-be-compressed data, whether the data point meets the translation prediction condition or whether the data point meets another prediction condition.

Based on the foregoing solution, in an implementation, if the to-be-compressed data includes a first data point, the first data point includes first position information and first data information, and the first apparatus may obtain a first prediction value based on original coordinates of a reference point in the historical frame and a translation prediction vector, that the first data point meets the time series translation prediction condition may include:

An error value between the first prediction value (which may be, for example, $p_2'$ in FIG. 8) and original coordinates (which may be, for example, $p_1$ in FIG. 8) corresponding to the first data point is less than or equal to a first threshold (which may be, for example, t1 in FIG. 8); or an error value between data information corresponding to the first prediction value in the target coordinate system and the first data information corresponding to the first data point is less than or equal to a second threshold. Position information of the first prediction value in the target coordinate system is the same as the first position information corresponding to the first data point. In addition, optionally, the reference point may be specifically a scanning position or another preset reference position used to predict data.

Optionally, in an implementation, the first apparatus and/or the second apparatus may further obtain third information, where the third information indicates coordinate information of a reference point corresponding to the first apparatus, and is used to calculate the translation prediction vector based on a position of the reference point in the historical frame and a position of the reference point in a current frame. For example, the third information may include coordinate information of a reference point, for example, a scanning position. In this case, the first apparatus and/or the second apparatus may perform calculation based on the coordinate information of the scanning position, to determine the translation prediction vector that is of the current frame and that is based on the historical frame. Alternatively, the third information may include a moving speed of the scanning position. In this case, the first apparatus and/or the second apparatus may perform calculation based on the moving speed of the scanning position and the time difference between the current frame and the historical frame, to determine the translation prediction vector that is of the current frame and that is based on the historical frame. A specific implementation or algorithm of the third information is not limited in this application.

In an implementation, the prediction type corresponding to the data information may include a second type. The second type is a data point type of a data point that is in the to-be-compressed data and that meets a planar prediction condition. Planar prediction may also be understood as prediction. To be specific, in a scenario in which a scanning position moves or is static, if a point on a plane in the historical frame and a point in the current frame are on a same plane, this feature may be used in an encoding and decoding process, and the coordinate information or the data information of the point in the current frame is obtained through prediction based on the coordinate information or the data information of the point in the historical frame.

Specifically, the first apparatus may determine, according to the following method, that a data point meets the planar prediction condition.

For example, as shown in FIG. 9, in a dynamic scanning scenario, a scanning position in a historical frame is $s_1$, a scanning position in a current frame may be $s_2$, and a movement vector corresponding to the scanning position in the current frame may be $\vec{U}$. In the 2D data structure diagram, 3D coordinate points of two neighbor frames at a same position are $p_1$ and $p_2$, $p_1$ and $p_2$ may be located on a same plane. Coordinates $p_1$ of may be obtained by the decoder side through prediction, or may be fed back by the encoder side to the decoder side for predicting recovered data.

Then, the first apparatus may perform prediction (for example, according to a fitting algorithm) based on $p_1$ and a nearest-neighbor point of $p_1$, to obtain a plane C in which the point is located. A direction (for example, a vertical angle and an azimuth) for sensing $p_2$ at the scanning position $s_2$ is the same as a direction (for example, a vertical angle and an azimuth) for sensing $p_1$ at the scanning position $s_1$. In this case, the first apparatus may obtain a projected point of $s_2$ in the direction on the plane C, that is, obtain a prediction point $p_2'$ of $p_2$. Based on a configured planar prediction threshold t2, if the first apparatus determines that an error value between a prediction value of the point and a real frame does not exceed the threshold, for example, the error value $\|\overrightarrow{p_2 - p_2'}\| \leq t2$, the decoder side may obtain the prediction coordinate of $p_2$ that is recovered is $p_2'$.

Based on the foregoing solution, in an implementation, if the to-be-compressed data includes a second data point, and the second data point includes second position information and second data information, the first apparatus may perform fitting processing based on a reference point in a historical frame and a plurality of neighbor points of the reference point to obtain a prediction plane (for example, the plane C shown in FIG. 9), and obtain a second prediction value based on the position information corresponding to the second data point and the prediction plane; and that the second data point meets the planar prediction condition includes:

An error value between the second prediction value (which may be, for example, $p_2'$ in FIG. 9) and original coordinates (which may be, for example, $p_1$ in FIG. 9) of the second data point is less than or equal to a third threshold (which may be, for example, t2 in FIG. 9); or an error value between data information corresponding to the second prediction value in the target coordinate system and the second data information corresponding to the second data point is less than or equal to a fourth threshold. The second prediction value is located on a prediction plane of the historical frame, and corresponds to a same position in 2D data structure diagrams of two neighbor frames.

It should be noted that the foregoing prediction type of the data point in this application is merely an example. In a specific implementation process, in addition to the foregoing translation prediction or planar prediction, a fifth type such as curved surface prediction, and/or another prediction manner of a geometric model may be further included, for example, a data point that meets a prediction condition of another function (the function may describe another complex model, for example, another line, plane, or body). This is not limited in this application.

In addition, it should be noted that each threshold in the foregoing embodiment may be set based on a compression performance requirement that needs to be met according to the data compression algorithm. This is not specifically described in this application.

In an implementation, the non-prediction type corresponding to the data information includes at least one of the following: a third type or a fourth type. The third type is a type of a data point that has no data information, and the fourth type is a type of a data point that has data information and that does not meet a condition corresponding to the prediction type.

Data information of a data point may be empty. In this case, the encoder side does not need to perform data compression encoding on the point, and a receiver only needs to recover the data information to empty based on a data point type when decoding and recovering the data. For the data point of the fourth type, because any prediction condition is not met, the encoder side may directly encode data information of the data point, or may perform inter-frame residual encoding. Residual encoding may mean that the encoder side may obtain an inter-frame residual based on data information of a data point at a same position in a 2D data structure corresponding to a current frame and a historical frame, and then encode the residual; or residual encoding may be a residual that is between a data point in the 2D data structure of the current frame and a nearest-neighbor point closest to the data point in the historical frame, and encode the residual. Based on this, the decoder side may perform decoding in a decoding mode corresponding to the encoding mode, to recover the data.

In an implementation, the first apparatus and the second apparatus each are configured with an indication of a type used for a data point, which may include, for example, a type of a data point used in a current data compression manner and identifier information (for example, marked as 0, 1, 2, or 3) corresponding to each type. For example, data point types configured by the first apparatus include: translation prediction-first type, marked as 1; planar prediction-second type, marked as 2; data information being empty-third type, marked as 0; and data information present and the prediction condition not met-fourth type, marked as 3. For example, the first apparatus may obtain a type corresponding to each data point in the to-be-encoded data, for example, obtain a 2D type graph shown in FIG. 10, to obtain the first information.

In an implementation, the first information may be specifically a first sequence, and the first sequence includes a type corresponding to each data point in the to-be-encoded data arranged in a specific order. For example, the arrangement order of the first sequence may be an order from top to bottom and from left to right. For example, the first sequence obtained based on the 2D type graph shown in FIG. 10 may be {4, 4, 2, 2, 2, 2, 3, 1, 4, 4, 4, 2, 4, 3, 2, ...}. Alternatively, the first information may be represented by using a matrix. The first apparatus may obtain a first matrix based on a type mark in the 2D type graph shown in FIG. 10. A representation manner of the first information is not limited in embodiments of this application. It can be learned that the first information may explicitly or implicitly include the position information of each data point, and a representation manner of first information may be determined by the encoder side and the decoder side based on a configuration, so that the decoder side can accurately recover a type of each data point in the to-be-encoded data based on the first information.

In addition, for different types of data points, a prediction type, and a type in which data information is empty, in an implementation, the encoder side may not send data information corresponding to the data point, but for a data point that is non-prediction type and that has data information and that does not meet a prediction condition, the encoder side needs to encode the data information and send the data information to the decoder side for data recovery.

Optionally, for the second information, the first apparatus may generate the second information based on the data information corresponding to the data point of the fourth type. Alternatively, in another implementation, to further enhance encoding reliability and improve compression performance, the first apparatus may further send a prediction error value (or the foregoing distance error) of the prediction type to the second apparatus, so that the second apparatus can perform data recovery based on the historical frame and the error value, thereby improving accuracy of the recovered data. The prediction error value may be an error between a real value and a prediction value of three-dimensional coordinates in the original coordinate system, or may be an error between a real value and a prediction value of data information in the target coordinate system.

In addition, in an implementation, the first apparatus may further perform entropy encoding on the first information and the second information with reference to an existing encoding algorithm, for example, arithmetic coding (Arithmetic coding, AC) or LZMA, to obtain the target coded data.

Correspondingly, after the first apparatus serves as an encoder side and outputs the target coded data, the second apparatus serves as a decoder side and may obtain the target coded data, and decode the target coded data to recover the data. It should be noted that the first apparatus may be a terminal, a network device, or an encoding apparatus or a chip in a network device. Similarly, the second apparatus may be a terminal, a network device, or a decoding apparatus or a chip in a network device. This is not limited in this application.

For the second apparatus, the method may include the following steps.

504: The second apparatus decodes the target coded data to obtain to-be-compressed data.

Specifically, the second apparatus may obtain, based on the first information in the target coded data, position information corresponding to each data point and a type corresponding to the data point in the to-be-compressed data. Then, the second apparatus may obtain, through decoding based on the type of the data point and the second information, data information corresponding to the position information of each data point in the to-be-compressed data. Data information corresponding to a data point of the prediction type is obtained through prediction based on a historical frame, and data information corresponding to a data point of the non-prediction type is obtained based on the second information.

In an implementation, the first apparatus performs coordinate mapping and/or quantization processing in the process of obtaining the to-be-encoded data in step 501. In this case, the second apparatus may further perform the following steps: performing coordinate mapping and/or dequantization processing on the to-be-compressed data corresponding to a target coordinate system, to obtain recovered data corresponding to an original coordinate system. For example, if the first apparatus maps the raw data in the Cartesian coordinate system to the spherical coordinate system, the second apparatus may map the data obtained through decoding from the spherical coordinate system to the Cartesian coordinate system to recover the raw data.

In the foregoing implementation of this application, according to the data compression method based on 2D data structure classification and filtering, a classification indication of a data point is designed, a type of the data point is indicated to a decoder side, different modes may be selected based on a feature of the data point for filtering or encoding, and different compression processing is performed on various types of data points. This can effectively improve encoding efficiency and compression performance.

The following describes a manner in which the first apparatus determines the data point type in the to-be-encoded data. In an implementation, the first apparatus may independently determine each data point to determine a corresponding type; or may sequentially determine each data point to determine a corresponding type.

Manner 1: Independently determining types

The first apparatus may sequentially determine a type that each data point in the 2D data structure meets. If a current data point meets a plurality of types, a type corresponding to the data point may be determined in several manners (which are not limited to the following several manners and are extensible).

1. A type is randomly selected from a plurality of types that meet the conditions.
2. If a prediction type is met, a type with a minimum prediction error is selected as the type corresponding to the data point. For example, a prediction error of translation prediction is less than a prediction error of planar prediction.

3. A type with a largest quantity is selected as the type corresponding to the data point based on a quantity of data points that meet each type.

Manner 2: Sequentially determining types

The first apparatus may determine, for data points included in the to-be-encoded data, one by one and in descending order of data point type priorities, types that the data points meet. In other words, the first apparatus sequentially traverses data points in the 2D data structure, and determines, based on the priority order of types, types that are satisfied by the data points; and if a type with a higher priority is met, the first apparatus no longer determines a subsequent data type with a lower priority.

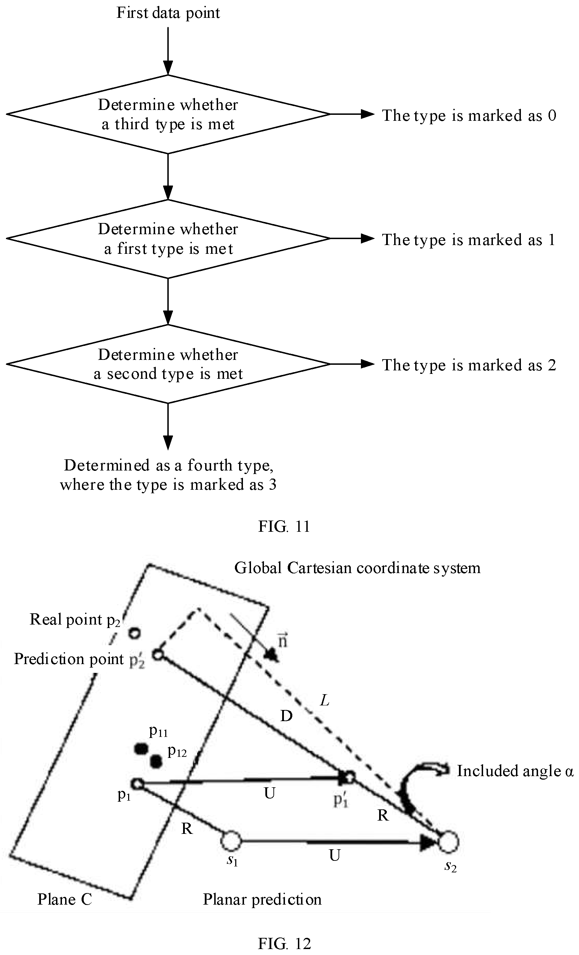

For example, as shown in FIG. 11, if the priority order corresponding to the data point types is: the third type (the data information is empty), the first type (translation prediction), the second type (planar prediction), and the fourth type (the data information is not empty and does not satisfy the prediction condition), that the first apparatus determines the type corresponding to the first data point includes the following steps:

Step 1: The first apparatus determines whether the first data point meets the third type 3, and if the first data point meets the third type 3, the type is marked as 0, and determining is terminated; otherwise, step 2 is performed.

Step 2: The first apparatus determines whether the first data point meets the first type, and if the first data point meets the first type, the type is marked as 1, and determining is terminated; otherwise, step 3 is performed.

Step 3: The first apparatus determines whether the first data point meets the second type, and if the first data point meets the second type, the type is marked as 2; otherwise, the type is marked as 3, and determining is terminated.

It can be learned that, for the foregoing manner 1, a compression rate and encoding performance are good, but an encoding delay is increased when all types that meet are determined for data points one by one. Optionally, the encoder side may determine, in parallel based on a plurality of different data blocks, a type that each data point meets, to reduce a delay.

It should be noted that a priority order of types is not specifically limited in this application. In an implementation, the encoder side and/or the decoder side may obtain the priority order corresponding to the data point types; or determine, based on a preconfiguration, the priority order corresponding to the data point types; or before an encoding and decoding procedure, the encoder side may send the priority order corresponding to the data point types to the decoder side.

In an implementation, the first apparatus and/or the second apparatus may obtain first indication information including an indication of a type used for the data point, to indicate the type used for the data point. Optionally, the method includes: The first apparatus sends the first indication information to the second apparatus. For example, the second apparatus is configured with data types including the first type, the second type, the third type, and the fourth type, and identifier information corresponding to each type. In an encoding compression processing process, if the first apparatus determines that the current data compression type includes only the first type, the fourth type, and the third type, the first apparatus may indicate the used data point type to the second apparatus based on the first indication information and an identifier corresponding to the indication type. Alternatively, the second apparatus sends the first indication information to the first apparatus, or the first apparatus or the second apparatus obtains the first indication information by using a configuration of another network element. This is not limited in this application.

In an implementation, for the foregoing second type of planar prediction, whether a data point meets a planar prediction condition is determined, the encoder side and the decoder side may determine scanning positions $s_1$ and $s_2$ of a historical frame and a current frame (for example, coordinate information of the scanning positions or speed information of movement of the scanning positions may be configured), and the encoder side and the decoder side may determine parameters (for example, sent by the encoder side to the decoder side or sent by the decoder side to the encoder side) such as a quantity of neighbor points and a position of a neighbor point of the fitting plane. In addition, the encoder side and the decoder side may determine that a direction (for example, a vertical angle and an azimuth) for sensing $p_2$ at the scanning position $s_2$ is the same as a direction (for example, a vertical angle and an azimuth) for sensing $p_1$ at the scanning position $s_1$, and $p_2'$ is a projection point of $s_2$ on the plane C in the direction.

Specifically, a process in which the encoder side determines the plane and resolves the prediction point may include the following process:

For example, as shown in FIG. 12, the scanning position in the historical frame is $s_1$, the scanning position in the current frame is $s_2$, and a movement vector corresponding to the scanning position in the current frame may be U. In the 2D data structure diagram, 3D coordinate points of two neighbor frames at a same position are $p_1$ and $p_2$, $p_1$ and $p_2$ may be located on a same plane, and a distance from $p_1$ to $s_1$ is R.

Determine the plane function C: If $f(p) = ax + by + cz + d$, plane C is defined as $f(p) = 0$. Based on the nearest-neighbor point ($p_{11}$, $p_{12}$, ... ) of the point $p_1$ of the previous frame in the 2D graph, a plane normal vector $\vec{n}=(a, b, c)$ may be calculated according to the following formula, and then a value of d is obtained by substituting $p_1$ into the formula. ($r_1\_x$, $r_1\_y$, $r_1\_z$) and ($r_2\_x$, $r_2\_y$, $r_2\_z$) are respectively three-axis coordinate values of

$$\overrightarrow{p_1p_{11}} \text{ and } \overrightarrow{p_1p_{12}}: \begin{cases} \vec{n} * \overrightarrow{p_1p_{11}} = 0 \\ \vec{n} * \overrightarrow{p_1p_{12}} = 0 \\ \vec{n} * \overrightarrow{p_1p_{13}} = 0 \\ \vdots \end{cases} \qquad \begin{cases} a * r_{1\_x} + b * r_{1\_y} + c * r_{1\_z} = 0 \\ a * r_{2\_x} + b * r_{2\_y} + c * r_{2\_z} = 0 \end{cases}.$$

Resolve a prediction point $p_2' (p_{2\_x}', p_{2\_y}', p_{2\_z}')$ : A distance from the position $s_2$ to the plane C is $L = \frac{||f(s_2)||}{||\vec{n}||} \cdot \overrightarrow{s_2p_2'}$ of the sensing device and the normal vector $\vec{n}$ is $\alpha$, a distance from $p_1'$ to $s_2$ is R, a distance from $p_2'$ to $s_2$ is D, and the prediction point $p_2'$ may be obtained according to the following formula:

$$\begin{cases} D = \dfrac{L}{cos\alpha} \\ \dfrac{D}{R} = \dfrac{p_{2\_x}'-s_{2\_x}}{p_{1\_x}-s_{1\_x}} = \dfrac{p_{2\_y}'-s_{2\_y}}{p_{1\_y}-s_{1\_y}} = \dfrac{p_{2\_z}'-s_{2\_z}}{p_{1\_z}-s_{1\_z}} \end{cases}.$$

The preset threshold is t2. If $||p_2 - p_2'|| \leq t2$ , the first apparatus determines that the data point that meets the planar prediction condition is of the second type, and the decoder side may recover the data point based on $p_2'$ .

Further, optionally, it is considered that if the first apparatus calculates a plane function for each data point, calculation complexity and a calculation amount are large, and an encoding delay is increased; and noise in a computational process may affect data prediction effect, the first apparatus may determine a type of each data point and a plane on which each data point is located in a prediction manner of a plane-multiplexed sliding block.

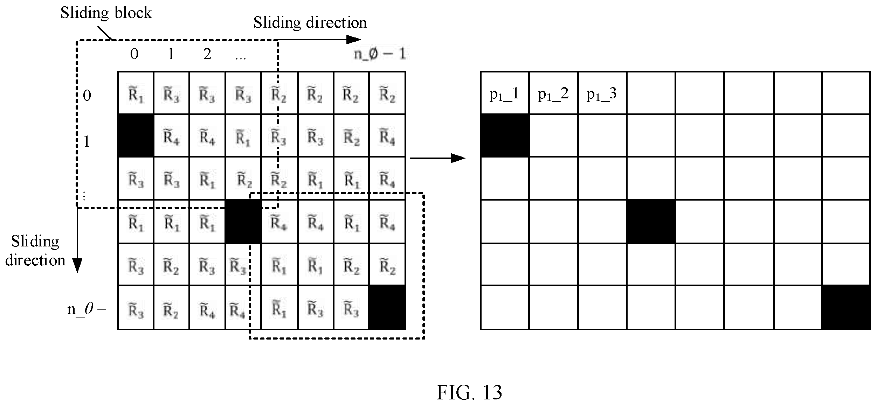

Specifically, the first apparatus may set a sliding block of a specific size. For example, a size of the sliding block is m*n. As shown in FIG. 13, m=4, n=3, and a sliding direction is from upper left to lower right. In this case, data points corresponding to upper left positions of the historical frame and the current frame in the first sliding block may be respectively denoted as $p_{1\_}1$ and $p_{2\_}1$.

As shown in FIG. 13, the first apparatus may determine a 4*3 sliding block near a point $p_{1\_}1$, and select k neighbor points to determine a plane C (generally, edge points of the sliding block may be selected, for example, three points shown in FIG. 12), to obtain a prediction value $p_{2\_}'1$ of the current frame on the plane C. Optionally, at least three points may be used to determine a plane, for example, a current point $p_{1\_}1$ and k neighbor points. It can be learned that k may be a positive integer greater than or equal to 2. In a possible case, if the current point $p_{1\_}1$ is located on a plane XOY, XOZ, or YOZ in the three-dimensional coordinate system, the encoder side may determine the plane based on the point $p_{1\_}1$ and at least one neighbor point. In this case, k may be a positive integer greater than or equal to 1.

If the predicted error value of is $d = ||p_{2\_}1 - p_{2\_}'1 || \leq t2$ , it is determined that $p_{1\_}1$ and $p_{2\_}1$ are on a same plane, and the type of the data point may be marked as a 2 in the 2D type graph.

Next, the second point $p_{1\_}2$ in the sliding block is predicted on the plane C, and a predicted error value d is calculated. If the error value is d $\leq$ t2, the type of the data point is marked as 2, and the third point $p_{1\_}3$ is still predicted on the plane C. If the error value is d>t2, the type of the data point is not marked as 2, and a subsequent point is no longer used to perform planar prediction on the previously generated plane. Subsequently, a new plane may be determined starting from the first data point after the data point, and planar prediction is performed.

In a decoding process of the decoder side, types of all data points in the 2D type graph may be sequentially traversed. If consecutive types are marked as the second type (for example, the types are marked as 2), the plane C may be determined by using the first data point of the second type that occurs, all subsequent data points of the second type may be predicted on the plane.

It should be noted that the encoder side and/or the decoder side may agree on or configure parameters such as determining a quantity k of neighbor points of a fitting plane and a position of a neighbor point. Optionally, the encoder side and/or the decoder side may agree on or configure parameters such as a size of the sliding block and a sliding direction of the sliding block. Optionally, the position of the neighbor point may be bound to a parameter m or n corresponding to the size of the sliding block. This manner is not limited in this application. The foregoing parameters can be obtained through simulation tests and then delivered to the encoder side and the decoder side based on a static or dynamic configuration.

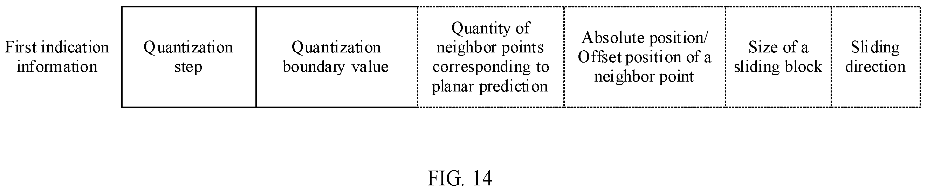

Optionally, the method includes: The first apparatus sends first indication information to the second apparatus, where the first indication information includes at least one of the following information: an indication of a type used for a data point, a quantity of neighbor points corresponding to planar prediction, an absolute position and/or an offset position of a neighbor point for planar prediction, a corresponding quantization step and a quantization boundary value for performing quantization processing on raw data, or a size of a sliding block and/or a sliding direction of the sliding block for performing block division processing on the to-be-encoded data. For example, the first indication information may include an indication field shown in FIG. 14.

The offset position of the neighbor point may include an offset value offset to the left and/or an offset value offset to the right. For example, for a data point in a data block, planar prediction may be performed based on a first neighbor point obtained by offsetting the data point to the right by a first offset position, a second neighbor point obtained by offsetting the data point to the left by a second offset position, and the like.

Based on the foregoing sliding processing manner, the first apparatus may divide the 2D data structure diagram into several parts, and each part performs sliding window prediction in parallel, so that a delay of data compression encoding can be further reduced.

Specifically, the first apparatus may divide the to-be-encoded data into blocks according to a division rule of a sliding block, to obtain a plurality of blocks of data, where each block of data includes a plurality of data points. The first apparatus may process the plurality of pieces of block data in parallel to obtain the first information and the second information that correspond to each piece of block data, and then perform data integration and compression encoding to obtain the target coded data, or perform encoding based on the block data and send the coded data to the decoder side.

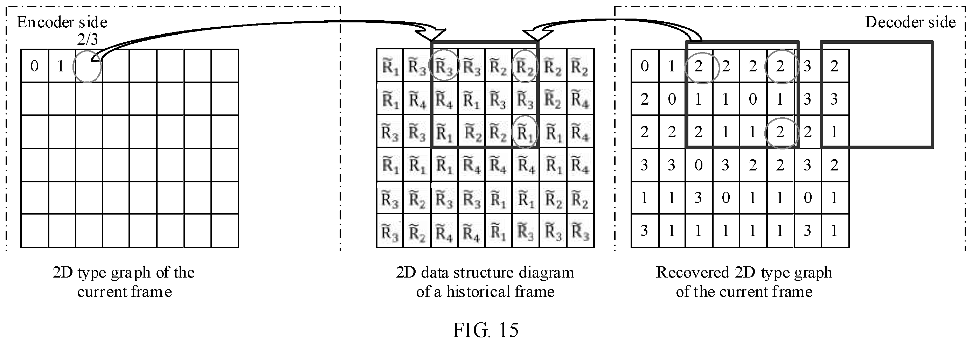

For example, as shown in FIG. 15, the encoder side sequentially determines, in a manner of sequentially determining types, a type corresponding to each data point, to obtain a 2D type graph, and may further obtain the first information and the second information. Correspondingly, the decoder side recovers the 2D type graph based on the received first information, sequentially traverses each data point in the 2D type graph, and recovers the data information to obtain the to-be-encoded data.

Further, for a data point of a prediction type, accuracy of prediction and recovering performed by the decoder side based on a historical frame cannot be ensured. Therefore, the target coded data in this application may be further extended. In an implementation, the data point of the prediction type may be encoded by using a prediction residual, that is, the encoder side may encode the prediction error value of the data point of the prediction type and send the encoded prediction error value to the decoder side, to further enhance decoding reliability.

In an implementation, the target coded data may include at least one of the following: coded data corresponding to a prediction error value of data information of the first type, coded data corresponding to a prediction error value of data information of the second type, position information of a plurality of nearest-neighbor points in the historical frame, or position information corresponding to data information of the fourth type and offset values of positions of a plurality of nearest-neighbor points in the historical frame. The nearest-neighbor point is a point that is found in the historical frame and that is closest to each data point.

Specifically, for the first type in the prediction types, that is, the translation prediction type, according to the foregoing solution, if a threshold of the translation prediction is configured as the threshold t1, and $\|p_2 - (p_1 + U)\| \leq t1$, the first apparatus may obtain a prediction error value $d = p_2 - (p_1 + U)$, and send the prediction error value to the second apparatus, so that the second apparatus can recover data based on $(p_1 + U) + d$.

In addition, similarly, for the second type in the prediction types, that is, the planar prediction type, according to the foregoing solution, if a threshold of the planar prediction is configured as the threshold t2, and $\|p_2 - p_2'\| < t2$, the first apparatus may obtain a prediction error value $d = p_2 - p_2'$, and send the prediction error value to the second apparatus, so that the second apparatus can recover the data based on $p_2' + d$. Similar to the foregoing description, the prediction error value may be an error between a real value and a prediction value of three-dimensional coordinates in the original coordinate system, or may be an error between a real value and a prediction value of data information in the target coordinate system.

Optionally, for data information corresponding to a data point of the fourth type in the non-prediction type, direct encoding may be performed based on the data information, or residual encoding may be performed based on a historical frame corresponding to the data information, for example, residual encoding is performed based on data information whose position information of a data point in the current frame is the same as that of a data point in the historical frame, or residual encoding is performed based on a residual value between a data point in the current frame and a nearest-neighbor point closest to the data point in the historical frame.

Optionally, for the data point of the fourth type, the target coded data may include: position information of a plurality of nearest-neighbor points in the historical frame, position information corresponding to the fourth-type data information, and offset values of positions of the plurality of nearest-neighbor points in the historical frame, where the nearest-neighbor point is a point that is in the historical frame and that is closest to a data point in the current frame.

In an implementation, the first apparatus and/or the second apparatus may obtain second indication information indicating that an encoding mode corresponding to the data information of the fourth type in the non-prediction type is performing residual encoding based on a historical frame corresponding to the data information, or performing direct encoding based on the data information.

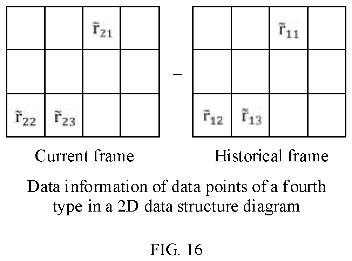

For example, the first apparatus may directly perform encoding based on the data information. If data information corresponding to the plurality of data points of the fourth type in the current frame is, for example, a sequence $\{\tilde{r}_{21}, \tilde{r}_{22}, \tilde{r}_{23}, ...\}$, as shown in FIG. 16, the first apparatus may directly encode the sequence and output the encoded sequence.

The first apparatus may obtain a residual value based on data information at a same position in the 2D data structure diagram corresponding to the historical frame and the current frame, and then perform residual encoding to obtain target coded data. As shown in FIG. 16, for example, residual values corresponding to the plurality of data points of the fourth type may be represented by using a residual sequence, for example, is $\{\tilde{r}_{21}\text{-}\tilde{r}_{11}, \tilde{r}_{22}\text{-}\tilde{r}_{12}, \tilde{r}_{23}\text{-}\tilde{r}_{13}, ...\}$, the first apparatus encodes the residual sequence and outputs the encoded residual sequence.

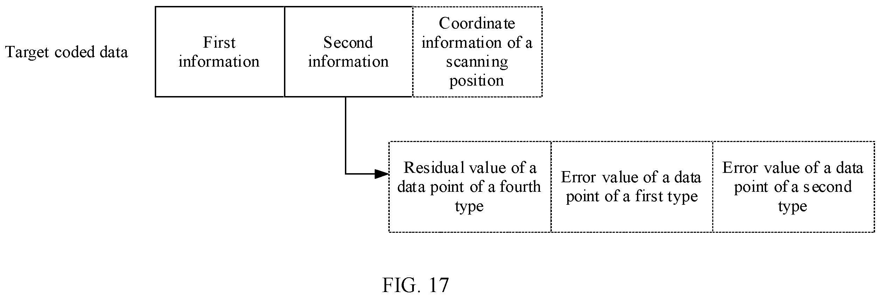

In conclusion, as shown in FIG. 17, for example, the target coded data output by the first apparatus may include the first information, that is, the 2D type graph, and further include the second information, that is, a data information encoded value of the to-be-encoded data. Optionally, the target coded data may further include the third information, for example, coordinate information indicating a scanning position. Optionally, the second information may specifically include residual coded data of the data point of the fourth type, and optionally, may further include error value coded data corresponding to the data point of the prediction type. In addition, optionally, if residual encoding is performed on the data point of the fourth type based on search for a nearest-neighbor point in the historical frame, the target coded data may further include position information of the nearest-neighbor point in the historical frame. For example, coordinate information of a nearest-neighbor point or offset information of a relative position may be specifically included.

In an implementation, the first apparatus and/or the second apparatus may obtain third indication information, and the third indication information indicates at least one of the following information: the first threshold, the second threshold, the third threshold, the fourth threshold, or indication information of a manner of determining a data point type in the to-be-encoded data. A manner of determining the data point type may include the foregoing manner of sequentially determining types, the foregoing manner of independently determining types, or the like.

Alternatively, optionally, the second indication information may include at least one of the following: the first threshold, the second threshold, the third threshold, the fourth threshold, or indication information of a manner of determining a data point type in the to-be-encoded data.

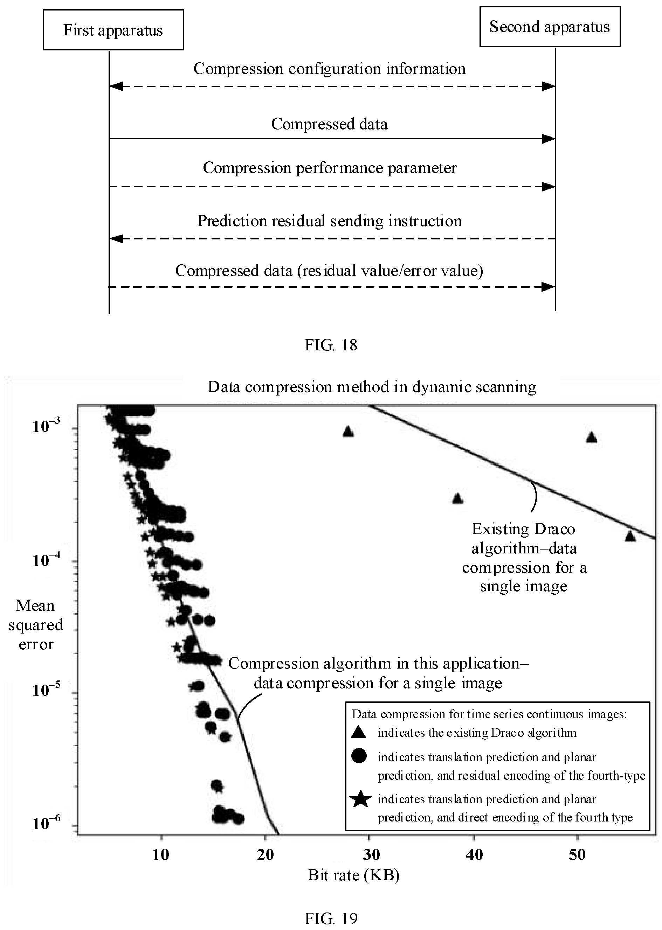

It should be noted that, in the foregoing embodiments of this application, the first indication information, the second indication information, and the third indication information may be collectively referred to as compression configuration information, and may be carried in a same piece of configuration signaling or a plurality of pieces of different configuration signaling. As shown in FIG. 18, the first apparatus and/or the second apparatus may obtain the compression configuration information from another network element or apparatus, or the first apparatus and the second apparatus may exchange some indication information in the compression configuration information.

Further, optionally, in an implementation, the encoder side may further indicate, to the decoder side, a currently calculated compression performance parameter (for example, a mean square error (Mean Square Error, MSE)), and the parameter indicates compression performance of a currently used encoding compression algorithm. In this way, the decoder side may determine, based on the compression performance, whether a requirement of current communication for compression performance or a communication condition is met. If the requirement is met, the decoder side may continue to use a currently used encoding and compression algorithm. If the requirement is not met, the decoder side may feed back to the encoder side to adjust the encoding and compression algorithm.

For example, the encoding compression algorithm preset by the encoder side and the decoder side is a mode of not sending a prediction type residual value. When determining, based on compression performance, that a current requirement is not met, the decoder side may send a prediction residual sending instruction to the encoder side. In this case, after receiving the instruction, the encoder side may adjust the encoding compression mode, and send, to the decoder side, an encoded data stream corresponding to the error value or the residual value corresponding to the data point of the prediction type, to improve data recovery performance.

In an implementation, before the encoder side indicates the encoding compression indication information to the decoder side, an index table of the compression configuration information may be configured on the encoder side and the decoder side. In other words, content in the foregoing compression configuration information may be configured in a form of a table, so that the encoder side may indicate, to the decoder side, an index value corresponding to the selected compression configuration information. An example is shown in the following Table 1.

Optionally, the index table may include a type of a selected predictable data point. For example, in data point types supported by the apparatus, $m_1$ indicates the first type, and $m_2$ indicates the second type.

Optionally, the index table may further include whether an encoding mode of the data point of the fourth type is direct encoding or residual encoding. For example, $c_1$ indicates direct encoding, and $c_2$ indicates residual encoding.

Table 1

| Prediction type | None | | $m_2$ | | $m_2$ | | $m_1$ and $m_2$ | |
|---|---|---|---|---|---|---|---|---|
| Encoding mode | $c_1$ | $c_2$ | $c_1$ | $c_2$ | $c_1$ | $c_2$ | $c_1$ | $c_2$ |
| Index value | 0 | 1 | 2 | 3 | 4 | 5 | 6 | 7 |

Optionally, a prediction parameter in the compression algorithm may be further configured by using an index table, for example, including parameters such as the first threshold or the second threshold corresponding to the translation prediction condition, the third threshold or the fourth threshold corresponding to the planar prediction condition, a size of a sliding block, and a sliding direction.

An example is shown in the following Table 2. The first threshold may be $T_{11}$ or $T_{12}$, the third threshold may be $T_{21}$ or $T_{22}$, and the size of the sliding block may include two groups, which are $(W_1, H_1)$ or $(W_2, H_2)$. The sliding direction may include two types: from upper left to lower right, or from lower right to upper left. Different combinations of the foregoing several parameters may one-to-one correspond to index values in the following Table 2. Therefore, the encoder side may indicate the index value to the decoder side, so as to determine the prediction parameter in the selected compression algorithm.

Table 2

| Index value | Prediction threshold | Size of the sliding block | Sliding direction | Quantity of neighbor points for planar prediction |
|---|---|---|---|---|
| 0 | $T_{11}$ and $T_{21}$ | $(W_1, H_1)$ | Upper left to lower right | 2 |
| 1 | | | | 3 |
| 2 | | | Lower right to upper left | 2 |
| 3 | | | | 3 |
| 4 | | $(W_2, H_2)$ | Upper left to lower right | 2 |
| 5 | | | | 3 |
| 6 | | | Lower right to upper left | 2 |
| 7 | | | | 3 |
| 8 | $T_{12}$ and $T_{22}$ | $(W_1, H_1)$ | Upper left to lower right | 2 |
| 9 | | | | 3 |
| 10 | | | Lower right to upper left | 2 |
| 11 | | | | 3 |
| 12 | | $(W_2, H_2)$ | Upper left to lower right | 2 |
| 13 | | | | 3 |
| 14 | | | Lower right to upper left | 2 |
| 15 | | | | 3 |

According to the foregoing implementation of this application, the encoder side may indicate the type of the data point to the decoder side, and may select different modes for filtering or encoding based on a feature of the data point, to perform different compression processing on various types of data points. This can effectively improve encoding efficiency and compression performance. For example, compression performance of an existing data compression algorithm may be compared with compression performance of the data compression algorithm in this application. For example, simulation calculation may be performed on mean square errors MSEs corresponding to different compression algorithms. It can be learned from the simulation diagram shown in FIG. 19 that the data compression algorithm provided in this embodiment of this application can effectively reduce the MSE and improve the compression performance.

Embodiments mentioned above in this application may be combined when the solutions do not conflict. This is not limited.

The foregoing mainly describes the solutions provided in this application from the perspectives of implementation and interaction processes of the encoder side and the decoder side. Correspondingly, this application further provides a communication apparatus. The communication apparatus may be the first apparatus or the second apparatus in the foregoing method embodiments, or may be a component that can be used in the first apparatus or the second apparatus, or may be a chip or a module configured to implement a function of the first apparatus or the second apparatus in the foregoing embodiments. It may be understood that, to implement the foregoing functions, the first apparatus or the second apparatus includes a corresponding hardware structure and/or software module for performing each function. A person skilled in the art should be easily aware that, in combination with units and algorithm operations of the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

It should be understood that the foregoing uses only the first apparatus or the second apparatus as an example to describe interaction between network elements. Actually, processing performed by the first apparatus is not limited to being performed by only a single network element, and processing performed by the second apparatus is not limited to being performed by only a single network element. For example, if the second apparatus is a network device, performed processing may be separately performed by at least one of the CU, the DU, and the RU.

In this application, the first apparatus and the second apparatus may be divided into functional modules based on the foregoing method examples. For example, functional modules corresponding to various functions are obtained through division, or two or more functions may be integrated into one processing module. The integrated module may be implemented in a form of hardware, or may be implemented in a form of a software functional module. It may be understood that division of the modules in this application is an example. The division is merely logical function division and may be other division in actual implementation.

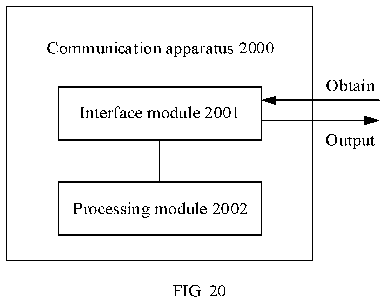

For example, when each functional module is obtained through division in an integrated manner, FIG. 20 is a diagram of a structure of a communication apparatus 2000. The communication apparatus 2000 includes an interface module 2001. The interface module 2001 may implement a corresponding communication function. In addition, the interface module 2001 may also be referred to as a transceiver module, a communication interface, a communication module, or the like.

The communication apparatus 2000 may further include a processing module 2002. The processing module 2002 is configured to perform data processing. Specifically, the processing module 2002 in this embodiment of this application may be mainly configured to perform data compression encoding processing or data decoding processing.

Optionally, the communication apparatus 2000 may further include a storage module. The storage module may be configured to store instructions and/or data. The processing module 2002 may read the instructions and/or the data in the storage module, so that the communication apparatus 2000 implements the foregoing method embodiments.

The communication apparatus 200 may be configured to perform an action performed by the first apparatus or the second apparatus in the foregoing method embodiments. Specifically, the communication apparatus 2000 may be the first apparatus or the second apparatus, or may be a component or an apparatus that can be configured in the first apparatus or the second apparatus. The processing module 2002 is configured to perform a processing-related operation of the first apparatus or the second apparatus in the foregoing method embodiments. The interface module 2001 is configured to perform a communication-related operation of the first apparatus or the second apparatus in the foregoing method embodiments.

Optionally, the interface module 2001 may include a sending module and a receiving module. The sending module is configured to perform the sending operation in the foregoing method embodiments. The receiving module is configured to perform the receiving operation in the foregoing method embodiments.

It should be noted that, the communication apparatus 2000 may include the sending module, but does not include the receiving module. Alternatively, the communication apparatus 2000 may include the receiving module, but not include the sending module. This may be specifically determined depending on whether the foregoing solutions performed by the communication apparatus 2000 include a sending action and a receiving action.

In some embodiments, the communication apparatus 2000 may further include a storage module (not shown in FIG. 20), configured to store program instructions and data.

For example, the communication apparatus 2000 may be configured to implement a function of the first apparatus in the foregoing embodiments. The communication apparatus 2000 is, for example, the first apparatus in the embodiment shown in FIG. 5.

The interface module 2001 is configured to obtain to-be-compressed data, where the to-be-compressed data includes position information corresponding to a data point and data information corresponding to the data point.

The processing module 2002 is configured to perform data compression based on the to-be-compressed data to obtain target coded data. The target coded data includes first information and second information, the first information indicates a type corresponding to the data information in the to-be-compressed data, the type corresponding to the data information includes a non-prediction type and at least one prediction type, and the second information includes data information corresponding to the non-prediction type in the to-be-compressed data.

The interface module 2001 is further configured to output the target coded data.

In an implementation, a prediction type corresponding to the data information includes at least one of the following: a first type or a second type. The first type is a data point type of a data point that is in the to-be-compressed data and that meets a time series translation prediction condition, and the second type is a data point type of a data point that is in the to-be-compressed data and that meets a planar prediction condition.

In an implementation, the non-prediction type corresponding to the data information includes at least one of the following: a third type or a fourth type. The third type is a type of a data point that has no data information, and the fourth type is a type of a data point that has data information and that does not meet a condition corresponding to the prediction type.

In an implementation, the prediction type corresponding to the data information includes a fifth type. The fifth type is a data point type of a data point that is in the to-be-compressed data and that meets a curved surface prediction condition.

In an implementation, the to-be-compressed data includes a first data point, the first data point includes first position information and first data information, and that the first data point meets the time series translation prediction condition includes: obtaining a first prediction value based on original coordinates of a reference point in a historical frame and a translation prediction vector. A distance error between the first prediction value and original coordinates corresponding to the first data point is less than or equal to a first threshold; or a distance error between data information corresponding to the first prediction value in a target coordinate system and the first data information corresponding to the first data point is less than or equal to a second threshold, where position information of the first prediction value in the target coordinate system is the same as the first position information corresponding to the first data point.

In an implementation, the interface module 2001 is further configured to obtain third information, where the third information indicates coordinate information of a reference point corresponding to the first apparatus, and is used to calculate the translation prediction vector based on a position of the reference point in the historical frame and a position of the reference point in a current frame.

In an implementation, the to-be-compressed data includes a second data point, the second data point includes second position information and second data information, and that the second data point meets the planar prediction condition includes: performing fitting processing based on a reference point in a historical frame and a plurality of neighbor points of the reference point to obtain a prediction plane; and obtaining a second prediction value based on the position information corresponding to the second data point and the prediction plane. A distance error between the second prediction value and original coordinates of the second data point is less than or equal to a third threshold; or a distance error between data information corresponding to the second prediction value in a target coordinate system and the second data information corresponding to the second data point is less than or equal to a fourth threshold, where the second prediction value is located on the prediction plane of the historical frame, and position information of the second prediction value in the target coordinate system is the same as the second position information corresponding to the second data point.

In an implementation, the interface module 2001 is further configured to obtain first indication information, where the first indication information includes at least one of the following information: an indication of a type used for a data point, a quantity of neighbor points corresponding to planar prediction, an absolute position or an offset position of a neighbor point for planar prediction, a quantization step and a quantization boundary value that correspond to quantization of raw data, or whether block division processing is performed on the to-be-encoded data, and a block size and/or a block sliding direction corresponding to block division processing.

In an implementation, the interface module 2001 is further configured to obtain second indication information indicating that an encoding mode corresponding to the data information of the non-prediction type is performing residual encoding based on a historical frame corresponding to the data information, or performing direct encoding based on the data information.

In an implementation, the second indication information further includes at least one of the following information: the first threshold, the second threshold, the third threshold, the fourth threshold, or indication information of a manner of determining a data point type in the to-be-encoded data.

In an implementation, the processing module 2002 is further configured to determine, based on the first indication information and/or the second indication information, whether the target coded data includes at least one of the following: coded data corresponding to a prediction error value of data information of the first type, coded data corresponding to a prediction error value of data information of the second type, or position information of a plurality of nearest-neighbor points in the historical frame, and/or position information corresponding to data information of the fourth type and offset values of positions of a plurality of nearest-neighbor points in the historical frame, where the nearest-neighbor point is a point that is in the historical frame and that is closest to a data point in the current frame.

In an implementation, the processing module 2002 is further configured to perform coordinate mapping and/or quantization processing on raw data corresponding to an original coordinate system of a current frame, to obtain to-be-encoded data corresponding to a target coordinate system.

In an implementation, the processing module 2002 is further configured to: determine, for each data point included in the to-be-encoded data, one by one and in descending order of data point type priorities, a type that the data point meets; and obtain the first information based on the type corresponding to each data point in the to-be-encoded data.

In an implementation, the interface module 2001 is further configured to obtain a priority order corresponding to the data point types.

In addition, the communication apparatus 2000 may be further configured to implement, for example, the second apparatus in the embodiment shown in FIG. 5.

The interface module 2001 is configured to obtain target coded data. The target coded data includes first information and second information, the first information indicates a type corresponding to data information in the to-be-compressed data, the type corresponding to the data information includes a non-prediction type and at least one prediction type, and the second information includes data information corresponding to the non-prediction type in the to-be-compressed data.

The processing module 2002 is configured to decode the target coded data to obtain the to-be-compressed data, where the to-be-compressed data includes position information corresponding to a data point and data information corresponding to the data point.

In an implementation, a prediction type corresponding to the data information includes at least one of the following: a first type or a second type. The first type is a data point type of a data point that is in the to-be-compressed data and that meets a time series translation prediction condition, and the second type is a data point type of a data point that is in the to-be-compressed data and that meets a planar prediction condition.

In an implementation, the non-prediction type corresponding to the data information includes at least one of the following: a third type or a fourth type. The third type is a type of a data point that has no data information, and the fourth type is a type of a data point that has data information and that does not meet a condition corresponding to the prediction type.

In an implementation, the prediction type corresponding to the data information includes a fifth type. The fifth type is a data point type of a data point that is in the to-be-compressed data and that meets a curved surface prediction condition.

In an implementation, the to-be-compressed data includes a first data point, the first data point includes first position information and first data information, and that the first data point meets the time series translation prediction condition includes: obtaining a first prediction value based on original coordinates of a reference point in a historical frame and a translation prediction vector. A distance error between the first prediction value and original coordinates corresponding to the first data point is less than or equal to a first threshold; or a distance error between data information corresponding to the first prediction value in a target coordinate system and the first data information corresponding to the first data point is less than or equal to a second threshold, where position information of the first prediction value in the target coordinate system is the same as the first position information corresponding to the first data point.

In an implementation, the interface module 2001 is further configured to obtain third information, where the third information indicates coordinate information of a reference point corresponding to the first apparatus, and is used to calculate the translation prediction vector based on a position of the reference point in the historical frame and a position of the reference point in a current frame.

In an implementation, the to-be-compressed data includes a second data point, the second data point includes second position information and second data information, and that the second data point meets the planar prediction condition includes: performing fitting processing based on a reference point in a historical frame and a plurality of neighbor points of the reference point to obtain a prediction plane; and obtaining a second prediction value based on the position information corresponding to the second data point and the prediction plane. A distance error between the second prediction value and original coordinates of the second data point is less than or equal to a third threshold; or a distance error between data information corresponding to the second prediction value in a target coordinate system and the second data information corresponding to the second data point is less than or equal to a fourth threshold, where the second prediction value is located on the prediction plane of the historical frame, and position information of the second prediction value in the target coordinate system is the same as the second position information corresponding to the second data point.

In an implementation, the interface module 2001 is further configured to obtain first indication information, where the first indication information includes at least one of the following information: an indication of a type used for a data point, a quantity of neighbor points corresponding to planar prediction, an absolute position or an offset position of a neighbor point for planar prediction, a quantization step and a quantization boundary value that correspond to quantization of raw data, or whether block division processing is performed on the to-be-encoded data, and a block size and/or a block sliding direction corresponding to block division processing.

In an implementation, the processing module 2002 is further configured to: obtain, based on the first information in the target coded data, position information corresponding to each data point and a type corresponding to the data point in the to-be-compressed data; and obtain, through decoding based on the type of the data point and the second information, data information corresponding to the position information of each data point in the to-be-compressed data, where data information corresponding to a data point of the prediction type is obtained through prediction based on a historical frame, and data information corresponding to a data point of the non-prediction type is obtained based on the second information.

In an implementation, the interface module 2001 is further configured to obtain second indication information indicating that an encoding mode corresponding to the data information of the non-prediction type is performing residual encoding based on a historical frame corresponding to the data information, or performing direct encoding based on the data information.

In an implementation, the second indication information further includes at least one of the following information: the first threshold, the second threshold, the third threshold, the fourth threshold, or indication information of a manner of determining a data point type in the to-be-encoded data.

In an implementation, the processing module 2002 is further configured to determine, based on the first indication information and/or the second indication information, whether the target coded data includes at least one of the following: coded data corresponding to a prediction error value of data information of the first type, coded data corresponding to a prediction error value of data information of the second type, or position information of a plurality of nearest-neighbor points in the historical frame, and/or position information corresponding to data information of the fourth type and offset values of positions of a plurality of nearest-neighbor points in the historical frame, where the nearest-neighbor point is a point that is in the historical frame and that is closest to a data point in the current frame.

In an implementation, the processing module 2002 is further configured to perform coordinate mapping and/or dequantization processing on the to-be-compressed data corresponding to a target coordinate system, to obtain recovered data corresponding to an original coordinate system.

When the communication apparatus 2000 is configured to implement functions of the first apparatus or the second apparatus in the foregoing embodiments, for other functions that can be implemented by the communication apparatus 2000, refer to related descriptions of the embodiment shown in FIG. 5. Details are not described again.

In a simple embodiment, a person skilled in the art may figure out that the communication apparatus 2000 may be in the form shown in FIG. 4. For example, the processor 401 in FIG. 4 may invoke the computer-executable instructions stored in the memory 403, to enable the communication apparatus 2000 to perform the method in the foregoing method embodiments.

In the foregoing embodiment, the processing module 2002 may be implemented by at least one processor or processor-related circuit. The interface module 2001 may be implemented by a transceiver or a transceiver-related circuit. The interface module 2001 may also be referred to as a transceiver module, a communication module, or a communication interface. Optionally, the storage module may be implemented via at least one memory.

For example, a function/implementation process of the interface module 2001 in FIG. 20 may be implemented through the communication interface 404 in FIG. 4.

For other implementations, refer to the detailed descriptions of the embodiment. Details are not described herein again.

It should be understood that a specific process in which the modules perform the foregoing corresponding process has been described in detail in the foregoing method embodiments. For brevity, details are not described herein again.

It may be understood that one or more of the foregoing modules or units may be implemented by using software, hardware, or a combination thereof. When any one of the foregoing modules or units is implemented by software, the software exists in a form of computer program instructions, and is stored in the memory. The processor may be configured to execute the program instructions and implement the foregoing method procedure. The processor may be built in an SoC (system-on-chip) or an ASIC, or may be an independent semiconductor chip. The processor may further include a necessary hardware accelerator, such as a field programmable gate array (field programmable gate array, FPGA), a PLD (programmable logic device), or a logic circuit that implements special logic operations, in addition to the core for executing software instructions to perform operations or processing.

When the foregoing modules or units are implemented by using hardware, the hardware may be any one or any combination of a CPU, a microprocessor, a digital signal processing (digital signal processing, DSP) chip, a microcontroller unit (microcontroller unit, MCU), an artificial intelligence processor, an ASIC, a SoC, an FPGA, a PLD, a dedicated digital circuit, a hardware accelerator, or a non-integrated discrete device, and the hardware may run necessary software or does not depend on software to perform the foregoing method procedures.

Optionally, this application further provides a chip system, including at least one processor and an interface. The at least one processor is coupled to a memory through the interface. When the at least one processor executes a computer program or instructions in the memory, the method in any one of the foregoing method embodiments is performed. In a possible implementation, the chip system further includes a memory. Optionally, the chip system may include a chip, or may include a chip and another discrete device. This is not specifically limited in this application.

Optionally, this application further provides a computer-readable storage medium. All or some of procedures in the foregoing method embodiments may be implemented by a computer program instructing related hardware. The program may be stored in the foregoing computer-readable storage medium. When the program is executed, the procedures in the foregoing method embodiments may be performed. The computer-readable storage medium may be an internal storage unit of the communication apparatus in any one of the foregoing embodiments, for example, a hard disk or memory of the communication apparatus. Alternatively, the computer-readable storage medium may be an external storage device of the communication apparatus, for example, a plug-in hard disk, a smart media card (smart media card, SMC), a secure digital (secure digital, SD) card, or a flash card (flash card) that is configured on the communication apparatus. Further, the computer-readable storage medium may include both an internal storage unit and an external storage device of the communication apparatus. The computer-readable storage medium is configured to store the computer program and store other programs and data that are required by the communication apparatus. The computer-readable storage medium may be further configured to temporarily store data that has been output or is to be output.

Optionally, this application further provides a computer program product. All or some of procedures in the foregoing method embodiments may be implemented by a computer program instructing related hardware. The program may be stored in the computer program product. When the program is executed, the procedures in the foregoing method embodiments may be performed.

Optionally, this application further provides computer instructions. All or some of procedures in the foregoing method embodiments may be completed by computer instructions instructing related hardware (for example, a computer, a processor, a network device, or a terminal). The program may be stored in the computer-readable storage medium or the computer program product.

Optionally, this application further provides a communication system, including the first apparatus and the second apparatus in the foregoing embodiments.

The foregoing descriptions about implementations allow a person skilled in the art to clearly understand that, for the purpose of convenient and brief description, division of the foregoing functional modules is taken as an example for illustration. In actual application, the foregoing functions can be allocated to different functional modules for implementation based on a requirement, that is, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate components may or may not be physically separate, and components displayed as units may be one or more physical units, may be located in one place, or may be distributed on different places. A part or all of the units may be selected based on an actual requirement to achieve the objectives of the solutions in embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

## Claims

1. A data compression method, applied to a first apparatus, wherein the method comprises:

   obtaining to-be-compressed data, wherein the to-be-compressed data comprises position information corresponding to a data point and data information corresponding to the data point;
   performing data compression based on the to-be-compressed data to obtain target coded data, wherein the target coded data comprises first information and second information, the first information indicates a type corresponding to the data information in the to-be-compressed data, the type corresponding to the data information comprises a non-prediction type and at least one prediction type, and the second information comprises data information corresponding to the non-prediction type in the to-be-compressed data; and
   outputting the target coded data.

2. A data compression method, applied to a second apparatus, wherein the method comprises:

   obtaining target coded data, wherein the target coded data comprises first information and second information, the first information indicates a type corresponding to data information in to-be-compressed data, the type corresponding to the data information comprises a non-prediction type and at least one prediction type, and the second information comprises data information corresponding to the non-prediction type in the to-be-compressed data; and

decoding the target coded data to obtain the to-be-compressed data, wherein the to-be-compressed data comprises position information corresponding to a data point and data information corresponding to the data point.

3. The method according to claim 1 or 2, wherein a prediction type corresponding to the data information comprises at least one of the following: a first type or a second type, wherein the first type is a data point type corresponding to a data point that is in the to-be-compressed data and that meets a time series translation prediction condition, and the second type is a data point type corresponding to a data point that is in the to-be-compressed data and that meets a planar prediction condition.

4. The method according to any one of claims 1 to 3, wherein a non-prediction type corresponding to the data information comprises at least one of the following: a third type or a fourth type, wherein the third type is a type of a data point that has no data information, and the fourth type is a type of a data point that has data information and that does not meet a prediction type condition.

5. The method according to claim 3, wherein the prediction type corresponding to the data information comprises a fifth type, wherein the fifth type is a data point type of a data point that is in the to-be-compressed data and that meets a curved surface prediction condition.

6. The method according to claim 3, wherein the to-be-compressed data comprises a first data point, the first data point comprises first position information and first data information, and that the first data point meets the time series translation prediction condition comprises:

obtaining a first prediction value based on original coordinates of a reference point in a historical frame and a translation prediction vector, wherein
a distance error between the first prediction value and original coordinates corresponding to the first data point is less than or equal to a first threshold; or
a distance error between data information corresponding to the first prediction value in a target coordinate system and the first data information corresponding to the first data point is less than or equal to a second threshold, wherein position information of the first prediction value in the target coordinate system is the same as the first position information corresponding to the first data point.

7. The method according to any one of claims 1 to 6, wherein the method further comprises:
obtaining third information, wherein the third information indicates coordinate information of a reference point corresponding to the first apparatus, and is used to calculate the translation prediction vector based on a position of the reference point in the historical frame and a position of the reference point in a current frame.

8. The method according to claim 4, wherein the to-be-compressed data comprises a second data point, the second data point comprises second position information and second data information, and that the second data point meets the planar prediction condition comprises:

performing fitting processing based on a reference point in a historical frame and a plurality of neighbor points of the reference point to obtain a prediction plane; and
obtaining a second prediction value based on the position information corresponding to the second data point and the prediction plane, wherein
a distance error between the second prediction value and original coordinates of the second data point is less than or equal to a third threshold; or
a distance error between data information corresponding to the second prediction value in a target coordinate system and the second data information corresponding to the second data point is less than or equal to a fourth threshold, wherein the second prediction value is located on the prediction plane of the historical frame, and position information of the second prediction value in the target coordinate system is the same as the second position information corresponding to the second data point.

9. The method according to claim 1, wherein obtaining the to-be-compressed data comprises:
performing coordinate mapping and/or quantization processing on raw data corresponding to an original coordinate system of a current frame, to obtain to-be-encoded data corresponding to a target coordinate system.

10. The method according to claim 1 or 9, wherein the method further comprises:

determining, for each data point comprised in the to-be-encoded data, one by one and in descending order of data point type priorities, a type that the data point meets; and

obtaining the first information based on the type corresponding to each data point in the to-be-encoded data.

11. The method according to any one of claims 1, 9 or 10, wherein the method comprises:
obtaining a priority order corresponding to the data point types.

12. The method according to any one of claims 1 to 11, wherein the method comprises:
obtaining first indication information, wherein the first indication information comprises at least one of the following information:
an indication of a type used for a data point, a quantity of neighbor points corresponding to planar prediction, an absolute position or an offset position of a neighbor point for planar prediction, a quantization step and a quantization boundary value that correspond to quantization of raw data, or whether block division processing is performed on the to-be-encoded data, or a block size and/or a block sliding direction corresponding to block division processing.

13. The method according to claim 2, wherein decoding the target coded data to obtain the to-be-compressed data comprises:

obtaining, based on the first information in the target coded data, position information corresponding to each data point and a type corresponding to the data point in the to-be-compressed data; and

obtaining, through decoding based on the type of the data point and the second information, data information corresponding to the position information of each data point in the to-be-compressed data, wherein data information corresponding to a data point of the prediction type is obtained through prediction based on a historical frame, and data information corresponding to a data point of the non-prediction type is obtained based on the second information.

14. The method according to claim 2 or 13, wherein the method further comprises:
performing coordinate mapping and/or dequantization processing on the to-be-compressed data corresponding to a target coordinate system, to obtain recovered data corresponding to an original coordinate system.

15. The method according to any one of claims 1 to 14, wherein the method further comprises:
obtaining second indication information indicating that an encoding mode corresponding to data information of the non-prediction type is residual encoding based on a historical frame corresponding to the data information, or performing direct encoding based on the data information.

16. The method according to claim 15, wherein the second indication information further comprises at least one of the following information: the first threshold, the second threshold, the third threshold, the fourth threshold, or indication information of a manner of determining a data point type in the to-be-encoded data.

17. The method according to any one of claims 1 to 16, wherein the method comprises:
determining, based on the first indication information and/or the second indication information, whether the target coded data comprises at least one of the following:
coded data corresponding to a prediction error value of data information of the first type, coded data corresponding to a prediction error value of data information of the second type, or position information of a plurality of nearest-neighbor points in the historical frame, and/or position information corresponding to data information of the fourth type and offset values of positions of a plurality of nearest-neighbor points in the historical frame, wherein the nearest-neighbor point is a point that is in the historical frame and that is closest to a data point in the current frame.

18. A communication apparatus, comprising a processor, wherein the processor is coupled to a memory, the memory is configured to store a program or instructions, and when the program or the instructions are executed by the processor, the method according to any one of claims 1 to 17 is performed.

19. A communication apparatus, wherein the communication apparatus comprises a processing module and an interface module, and is configured to perform the method according to any one of claims 1 to 17.

20. A computer-readable storage medium, wherein the computer-readable storage medium stores a computer program or instructions, and when the computer program or the instructions are executed, the method according to any one of claims 1 to 17 is performed.

21. A computer program product, wherein the computer program product comprises computer program code, and when the computer program code is run on a computer, the method according to any one of claims 1 to 17 is performed.

22. A communication system, wherein the communication system comprises a communication apparatus that performs the method according to claim 1 and a communication apparatus that performs the method according to claim 2.

FIG. 1

FIG. 2

FIG. 3

EP 4 783 464 A1

40

401    407    403

Processor    Processor    

CPU 0    CPU 0    

CPU 1    CPU 1    

Communication
line 402

Memory

404    405    406

Communication
interface    Output device    Input device

FIG. 4

First
apparatus    Second
apparatus

501: Obtain to-be-
compressed data

502: Perform data compression based on the to-be-
compressed data to obtain target coded data

503: Output the target coded data, and
correspondingly, the second apparatus
obtains the target coded data

504: Decode the target coded data to
obtain to-be-compressed data

FIG. 5

(x, y, z)

(θ, φ, r)

FIG. 6

|  | 0 | 1 | 2 | ... |  |  |  | n_∅ − 1 |
|---|---|---|---|---|---|---|---|---|
| 0 | $\widetilde{R}_1$ | $\widetilde{R}_3$ | $\widetilde{R}_3$ | $\widetilde{R}_3$ | $\widetilde{R}_2$ | $\widetilde{R}_2$ | $\widetilde{R}_2$ | $\widetilde{R}_2$ |
| 1 | ■ | $\widetilde{R}_4$ | $\widetilde{R}_4$ | $\widetilde{R}_1$ | $\widetilde{R}_3$ | $\widetilde{R}_3$ | $\widetilde{R}_2$ | $\widetilde{R}_4$ |
| ⋮ | $\widetilde{R}_3$ | $\widetilde{R}_3$ | $\widetilde{R}_1$ | $\widetilde{R}_2$ | $\widetilde{R}_2$ | $\widetilde{R}_1$ | $\widetilde{R}_1$ | $\widetilde{R}_4$ |
|  | $\widetilde{R}_1$ | $\widetilde{R}_1$ | $\widetilde{R}_1$ | ■ | $\widetilde{R}_4$ | $\widetilde{R}_4$ | $\widetilde{R}_1$ | $\widetilde{R}_4$ |
|  | $\widetilde{R}_3$ | $\widetilde{R}_2$ | $\widetilde{R}_3$ | $\widetilde{R}_3$ | $\widetilde{R}_1$ | $\widetilde{R}_1$ | $\widetilde{R}_2$ | $\widetilde{R}_2$ |
| n_θ − | $\widetilde{R}_3$ | $\widetilde{R}_2$ | $\widetilde{R}_4$ | $\widetilde{R}_4$ | $\widetilde{R}_1$ | $\widetilde{R}_3$ | $\widetilde{R}_3$ | ■ |

FIG. 7

Translation prediction

FIG. 8

Planar prediction

FIG. 9

| 4 | 4 | 2 | 2 | 2 | 2 | 3 |
|---|---|---|---|---|---|---|
| 1 | 4 | 4 | 4 | 2 | 4 | 3 |
| 2 | 2 | 2 | 4 | 4 | 2 | 2 |
| 3 | 3 | 3 | 1 | 2 | 2 | 2 |
| 4 | 4 | 3 | 3 | 4 | 4 | 4 |

FIG. 10

First data point

Determine whether
a third type is met → The type is marked as 0

Determine whether
a first type is met → The type is marked as 1

Determine whether
a second type is met → The type is marked as 2

Determined as a fourth type,
where the type is marked as 3

FIG. 11

Global Cartesian coordinate system

Real point $p_2$

Prediction point $p_2'$

$\vec{n}$

$L$

$D$

$p_{11}$

$p_{12}$

Included angle $\alpha$

$p_1$

U

$p_1'$

R

R

$s_1$

U

$s_2$

Plane C

Planar prediction

FIG. 12

EP 4 783 464 A1

FIG. 13

First indication information

| Quantization step | Quantization boundary value | Quantity of neighbor points corresponding to planar prediction | Absolute position/ Offset position of a neighbor point | Size of a sliding block | Sliding direction |

FIG. 14

Encoder side
2/3

| 0 | 1 |  |  |  |  |
|---|---|---|---|---|---|
|  |  |  |  |  |  |
|  |  |  |  |  |  |
|  |  |  |  |  |  |
|  |  |  |  |  |  |
|  |  |  |  |  |  |

2D type graph of the
current frame

| $\tilde{R}_1$ | $\tilde{R}_3$ | $\tilde{R}_3$ | $\tilde{R}_3$ | $\tilde{R}_2$ | $\tilde{R}_2$ | $\tilde{R}_2$ | $\tilde{R}_2$ |
|---|---|---|---|---|---|---|---|
| $\tilde{R}_1$ | $\tilde{R}_4$ | $\tilde{R}_4$ | $\tilde{R}_1$ | $\tilde{R}_3$ | $\tilde{R}_3$ | $\tilde{R}_2$ | $\tilde{R}_4$ |
| $\tilde{R}_3$ | $\tilde{R}_3$ | $\tilde{R}_1$ | $\tilde{R}_2$ | $\tilde{R}_2$ | $\tilde{R}_1$ | $\tilde{R}_1$ | $\tilde{R}_4$ |
| $\tilde{R}_1$ | $\tilde{R}_1$ | $\tilde{R}_1$ | $\tilde{R}_4$ | $\tilde{R}_4$ | $\tilde{R}_4$ | $\tilde{R}_1$ | $\tilde{R}_4$ |
| $\tilde{R}_3$ | $\tilde{R}_2$ | $\tilde{R}_3$ | $\tilde{R}_3$ | $\tilde{R}_1$ | $\tilde{R}_1$ | $\tilde{R}_2$ | $\tilde{R}_2$ |
| $\tilde{R}_3$ | $\tilde{R}_2$ | $\tilde{R}_4$ | $\tilde{R}_4$ | $\tilde{R}_1$ | $\tilde{R}_3$ | $\tilde{R}_3$ | $\tilde{R}_3$ |

2D data structure diagram
of a historical frame

| 0 | 1 | 2 | 2 | 2 | 2 | 3 | 2 |
|---|---|---|---|---|---|---|---|
| 2 | 0 | 1 | 1 | 0 | 1 | 3 | 3 |
| 2 | 2 | 2 | 1 | 1 | 2 | 2 | 1 |
| 3 | 3 | 0 | 3 | 2 | 2 | 3 | 2 |
| 1 | 1 | 3 | 0 | 1 | 1 | 0 | 1 |
| 3 | 1 | 1 | 1 | 1 | 1 | 3 | 1 |

Recovered 2D type graph
of the current frame

Decoder side

FIG. 15

|  |  | $\tilde{r}_{21}$ |  |
|---|---|---|---|
|  |  |  |  |
| $\tilde{r}_{22}$ | $\tilde{r}_{23}$ |  |  |

−

|  |  | $\tilde{r}_{11}$ |  |
|---|---|---|---|
|  |  |  |  |
| $\tilde{r}_{12}$ | $\tilde{r}_{13}$ |  |  |

Current frame      Historical frame

Data information of data points of a fourth
type in a 2D data structure diagram

FIG. 16

Target coded data

| First information | Second information | Coordinate information of a scanning position |
| --- | --- | --- |

| Residual value of a data point of a fourth type | Error value of a data point of a first type | Error value of a data point of a second type |
| --- | --- | --- |

FIG. 17

FIG. 18

Data compression method in dynamic scanning

FIG. 19

Communication apparatus 2000

Interface module 2001

Obtain

Output

Processing module 2002

FIG. 20

## INTERNATIONAL SEARCH REPORT

| International application No. |
| --- |
| **PCT/CN2023/127332** |

**A.  CLASSIFICATION OF SUBJECT MATTER**

H03M7/30(2006.01)i

According to International Patent Classification (IPC) or to both national classification and IPC

**B.  FIELDS SEARCHED**

Minimum documentation searched (classification system followed by classification symbols)

Documentation searched other than minimum documentation to the extent that such documents are included in the fields searched

H03M

Electronic data base consulted during the international search (name of data base and, where practicable, search terms used)

CNABS, DWPI, CNTXT, USTXT, CNKI: 编码, 类型, 属性, 数据, 数据点, 数据压缩, 压缩, 优先级, 预测, 预期, 坐标, compression, style, predict, type, date, code

**C.  DOCUMENTS CONSIDERED TO BE RELEVANT**

| Category* | Citation of document, with indication, where appropriate, of the relevant passages | Relevant to claim No. |
| --- | --- | --- |
| Y | CN 102792689 A (QUALCOMM INC.) 21 November 2012 (2012-11-21) description, paragraphs 15-47 | 1-5, 7, 9-22 |
| Y | CN 116016953 A (SUN YAT-SEN UNIVERSITY et al.) 25 April 2023 (2023-04-25) description, paragraphs 67-164 | 1-5, 7, 9-22 |
| Y | CN 106374934 A (CHINA UNIVERSITY OF GEOSCIENCES (WUHAN)) 01 February 2017 (2017-02-01) description, paragraphs 18-29 | 10-11 |
| A | WO 2020167097 A1 (LG ELECTRONICS INC.) 20 August 2020 (2020-08-20) entire document | 1-22 |
| A | US 2021076028 A1 (LG ELECTRONICS INC.) 11 March 2021 (2021-03-11) entire document | 1-22 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **21 November 2023** | **21 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/127332**

| Patent document cited in search report | | | Publication date (day/month/year) | Patent family member(s) | | | Publication date (day/month/year) |
|---|---|---|---|---|---|---|---|
| CN | 102792689 | A | 21 November 2012 | EP | 2543193 | A1 | 09 January 2013 |
| | | | | WO | 2011109555 | A1 | 09 September 2011 |
| | | | | KR | 20120138239 | A | 24 December 2012 |
| | | | | KR | 101389820 | B1 | 29 April 2014 |
| | | | | JP | 2013521717 | A | 10 June 2013 |
| | | | | JP | 5726919 | B2 | 03 June 2015 |
| | | | | US | 2011216829 | A1 | 08 September 2011 |
| CN | 116016953 | A | 25 April 2023 | None | | | |
| CN | 106374934 | A | 01 February 2017 | None | | | |
| WO | 2020167097 | A1 | 20 August 2020 | None | | | |
| US | 2021076028 | A1 | 11 March 2021 | KR | 20200108085 | A | 16 September 2020 |
| | | | | KR | 102476280 | B1 | 13 December 2022 |
| | | | | US | 11706405 | B2 | 18 July 2023 |
| | | | | US | 2023308637 | A1 | 28 September 2023 |
| | | | | WO | 2019190181 | A1 | 03 October 2019 |
| | | | | KR | 20220165288 | A | 14 December 2022 |

Form PCT/ISA/210 (patent family annex) (July 2022)